(19) Europäisches Patentamt
European Patent Office
Office européen des brevets

(11) Numéro de publication: **0 188 961**
**B1**

(12)
# FASCICULE DE BREVET EUROPÉEN

(45) Date de publication du fascicule du brevet: **27.12.89**

(51) Int. Cl.⁴: **H 01 J 37/256**

(21) Numéro de dépôt: **85402595.4**

(22) Date de dépôt: **20.12.85**

(54) **Appareil pour la micro-analyse à très haute résolution d'un échantillon solide.**

(30) Priorité: **28.12.84 FR 8420053**

(43) Date de publication de la demande:
**30.07.86 Bulletin 86/31**

(45) Mention de la délivrance du brevet:
**27.12.89 Bulletin 89/52**

(84) Etats contractants désignés:
**DE FR GB IT NL SE**

(56) Documents cité:
**DE-A-3 144 604**
**FR-A-2 532 111**
**US-A-3 617 739**

**NUCLEAR INSTRUMENTS & METHODS IN PHYSICS RESEARCH, vol. 187, no. 1, août 1981, pages 143-151, North-Holland Publishing Co., Amsterdam, NL; H. LIEBL: "Beam optics in secondary ion mass spectrometry"**

(73) Titulaire: **Office National d'Etudes et de Recherches Aérospatiales (O.N.E.R.A.), 29 Avenue de la Division Leclerc, F-92320 Châtillon-sous- Bagneux (FR)**
Titulaire: **UNIVERSITE DE PARIS- SUD, 15, rue Georges Clémenceau, F-91405 Orsay (FR)**

(72) Inventeur: **Slodzian, Georges, 15, rue Berlioz, F-92330 Sceaux (FR)**
Inventeur: **Daigne, Bernard, 47, chemin de la Vallée aux Loups, F-92290 Chatenay Malabry (FR)**
Inventeur: **Girard, François, 18, rue Ferrus, F-75014 Paris (FR)**

(74) Mandataire: **Plaçais, Jean- Yves, Cabinet Netter 40, rue Vignon, F-75009 Paris (FR)**

EP 0 188 961 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1989

## Description

L'invention a pour objet l'analyse élémentaire et isotopique de très petits volumes de matière prélevée à la surface d'un échantillon solide.

Jusqu'à présent, on utilise à cet effet un appareil tel que le microscope ionique modèle IMS - 3F de la société française CAMECA. A cet appareil correspondent les brevets français suivants : 1 240 658 déposé le 30 - 7 - 59; 1 352 167 déposé le 28 - 11.62; 1 576 381 déposé le 16 - 2 - 68; demande de brevet 83 00 538 déposée le 14 - 1 - 83, et publiée sous le numéro 2 542 089 (voir aussi EP-A-0 114 765).

Le principe du microscope ionique peut être résumé ainsi: une cible est bombardée à l'aide d'un faisceau d'ions primaires, tous de même nature, et d'énergie contrôlée, couvrant toute la surface visualisée. Chaque point de la cible, sous l'effet de ce bombardement, libère des atomes qui s'y trouvent. Une partie notable de ces atomes peut s'ioniser spontanément au cours du processus d'éjection et constitue des ions secondaires positifs ou négatifs, caractéristique de la composition chimique et isotopique du volume érodé. Le faisceau d'ions secondaires ainsi créés est repris pour former une image ionique de l'échantillon, et pour être analysé séquentiellement par un spectromètre de masse.

L'appareil connu a permis d'importants progrès, par ses qualités de sensibilité de détection, et de résolution en masse, en même temps que par son aptitude à fournir une "image ionique" pour chaque élément présent dans l'échantillon solide analysé.

Il se pose maintenant le problème d'améliorer encore la résolution, notamment en son caractère spatial, et la sensibilité de détection, ainsi que de réaliser la détection simultanée de plusieurs éléments, condition essentielle pour pouvoir analyser de très petits volumes de matière par une méthode destructive, une autre condition étant de disposer d'un moyen indépendant et non-destructif d'observation préalable de l'échantillon.

La présente invention a pour objectif d'apporter une solution à ce problème.

L'un des buts de l'invention est de permettre la focalisation d'une seconde fine et intense d'ions primaires (1 µm à 20 nm ou 200 Angströms), de façon compatible avec une collecte très efficace des ions secondaires émis dans un angle solide très grand et dispersés sur une bande énergétique de plusieurs dizaines d'électron-volts.

Un autre but de l'invention est de permettre une observation simultanée de l'échantillon par microscopie électronique à balayage opérant sur les électrons secondaires, ou bien sur les électrons transmis, ou encore sur les électrons rétrodiffusés.

Un troisième but de l'invention est de réaliser un appareil qui effectue conjointement un balayage sur les ions et les électrons primaires, de manière à produire simultanément les images ioniques donnant chacune la distribution d'un élément présent à la surface de l'échantillon et l'image électronique du microscope à balayage.

Ce balayage doit être compatible avec l'analyse simultanée (parallèle) des différents ions secondaires libérés par chacun des points explorés de la cible, en conservant une grande sensibilité et une haute résolution en masse (spectromètre de masse à détection multiple simultanée, et à haute résolution).

Il faut aussi que ce balayage soit compatible avec la focalisation du faisceau d'ions primaires en une sonde qui doit rester fine quelle que soit sa position sur la surface.

Il faut encore que le balayage permette de conserver les qualités requises des faisceaux secondaires d'ions et d'électrons.

L'invention a aussi pour but de permettre le passage simultané de quatre faisceaux d'énergies différentes sur un même axe optique, de manière compatible avec des réglages indépendants pour chacun de ces faisceaux.

Encore un autre but de l'invention est de réaliser un appareil de faible encombrement. Ceci est important notamment à cause de la stabilité mécanique et du vide poussé nécessaires au bon fonctionnement de l'appareil.

L'appareil proposé est comparable à l'appareil CAMECA précité en ce qu'il comporte, dans une enceinte mise sous vide:

- un porte-objet mobile, propre à recevoir l'échantillon à analyser;
- une source d'ions primaires;
- de premiers moyens optiques électrostatiques pour amener un faisceau d'ions primaires issus de la source à bombarder l'échantillon; et
- de seconds moyens optiques électrostatiques pour collecter des ions secondaires émis par l'échantillon, en réponse aux ions primaires qui le bombardent, et pour amener le faisceau d'ions secondaires ainsi collectés à l'entrée d'un analyseur d'ions, comprenant un spectomètre de masse.

Des structures analogues sont décrites dans US-A-3 617 739 et dans l'article NUCLEAR INSTRUMENTS & METHODS IN PHYSICS RESEARCH, vol. 187, n°1, août 1981, pages 143 - 151, North-Holland Publishing Co., Amsterdam, NL; H. LIEBL, "Beam optics in secondary ion mass spectrometry".

Par ailleurs, le document FR-A-2 532 111 décrit une lentille applicable en spectrométrie de masse, où

- les premiers et seconds moyens optiques électrostatiques comportent une partie optique commune à éléments coaxiaux, d'axe perpendiculaire au porte-objet et s'étendant jusqu'au voisinage de celui-ci, pour traiter simultanément, par les mêmes organes optiques, les faisceaux d'ions primaires et secondaires.

Selon un premier aspect de l'invention, l'appareil selon l'invention est remarquable par les caractéristiques suivantes:

- les premiers et seconds moyens optiques électrostatiques comportent une partie optique commune et coaxiale, d'axe perpendiculaire au porte-objet, et s 'étendant jusqu'au voisinage de celui-ci, pour réaliser une collecte très efficace des ions secondaires, tout en traitant simultanément, par les mêmes organes optiques, les faisceaux d'ions primaires et secondaires;
- les premiers et seconds moyens optiques comportent, à l'extrémité de ladite partie optique commune, opposée à l'échantillon, des moyens propres à imprimer un balayage du faisceau primaire d'ions dont le centre de pivotement se trouve sur l'axe de la partie commune, associée à des moyens propres à assurer une correction dynamique synchrone du faisceau d'ions secondaires dont le centre de pivotement se trouve au niveau d'une image du "cross-over", donnée par l'optique de collecte des ions secondaires;
- il est prévu un moyen de séparer les faisceaux d'ions primaires et secondaires; et
- il est prévu un moyen autonome d'observation électronique, comprenant des organes optiques magnétiques incorporés coaxialement à la partie optique commune, réglables de façon sensiblement découplée des premiers et seconds moyens optiques électrostatiques, ainsi que des moyens pour appliquer un champ magnétique transverse à ladite extrémité de la partie optique commune, afin de séparer les faisceaux d'électrons et d'ions, ce qui permet l'obtention simultanée d'une image ionique et d'une image électronique de l'échantillon.

De préférence, le moyen autonome d'observation est agencé en microscope électronique à balayage, dont les moyens de balayage électronique sont incorporés à ladite partie optique commune.

Selon un autre aspect de l'invention, la partie optique commune comporte une lentille électrostatique amenant le centre de pivotement du balayage primaire au centre du diaphragme qui délimite l'ouverture angulaire du faisceau primaire et une optique rapprochée propre à coopérer avec l'échantillon pour,

- d'une part réaliser la focalisation d'une image réduite de la source d'ions (sonde ionique) sur la surface de l'échantillon, focalisation qui peut être modulée en synchronisme avec le balayage pour corriger la mise au point en fonction de la position de la sonde sur la surface (correction dynamique de défocalisation),
- d'autre part réaliser une collecte large et efficace tant des électrons que des ions secondaires, en formant des images ionique et électronique au voisinage du même diaphragme.

Dans un mode de réalisation avantageux, l'optique rapprochée comprend, du diaphragme à l'échantillon:

- une électrode annulaire, mise à la masse;
- une électrode de contrôle de la collection, alimentée avec la même polarité que l'échantillon;
- une électrode de focalisation alimentée avec la polarité opposée; et
- une électrode annulaire placée au voisinage de l'échantillon pour en délimiter la surface susceptible de perturber les champs électriques de focalisation, et alimentée avec la même polarité que l'échantillon, laquelle est opposée à celle des ions primaires incidents.

Typiquement, pour des ions primaires positifs et des ions secondaires négatifs, l'énergie du faisceau d'ions primaire est de 10 keV en amont de l'optique rapprochée, pour être portée à 15 keV par la coopération de cette optique rapprochée avec l'échantillon porté au potentiel de -5 keV, tandis que l'énergie des ions secondaires est égale à 5 keV au niveau du diaphragme.

Par ailleurs, l'appareil comporte avantageusement une lentille magnétique au voisinage du diaphragme de l'optique rapprochée.

Plus généralement, l'optique rapprochée fait partie d'une optique de formation de la sonde ionique et de collecte, qui comporte encore une lentille électrostatique en amont du diaphragme.

Dans son ensemble, la partie commune coaxiale comporte, en amont de cette optique de formation de sonde et de collection:

- un combinateur-séparateur de faisceaux comprenant une paire de plaques électrostatiques, et définissant le centre de pivotement;
- une optique de mise en forme des faisceaux ioniques et électroniques; et
- des moyens de balayage des faisceaux électroniques.

Dans l'application en microscope électronique à balayage, l'optique de mise en forme comprend une lentille magnétique suivie de deux lentilles électrostatiques polarisées par des tensions opposées, et les moyens de balayage comprennent deux bobines électromagnétiques disposées l'une derrière l'autre.

Pour leur, part, les moyens de balayage ionique sur le faisceau primaire et de correction synchrone sur le faisceau secondaire comprennent de préférence deux paires de plaques placées à la suite de deux secteurs électrostatiques, du côté des ions primaires, et deux paires de plaques précédant deux secteurs électrostatiques du côté des ions secondaires.

Avantageusement, il est alors prévu d'une part une lentille électrostatique de couplage entre les deux secteurs électrostatiques primaires, et d'autre part une fente de filtrage d'énergie suivie d'une lentille électrostatique de couplage entre les deux secteurs électrostatiques secondaires, l'ensemble étant agencé pour produire des déviations d'ions sensiblement achromatiques au premier ordre.

De leur côté, les premiers moyens optiques comportent, après la source d'ions, une optique de réglage du diamètre de la sonde ionique.

Ainsi, les premiers moyens optiques forment des images successivement réduites de la source d'ions, tandis que les images secondaires, ionique et électronique, formées au voisinage du diaphragme, possèdent un grandissement sensiblement égal à l'unité.

A l'autre extrémité de l'appareil, l'analyseur d'ions comprend avantageusement une optique de transfert suivie d'un spectromètre de masse à grande clarté, capable de détection multiple simultanée.

Comme source d'électrons primaires, l'appareil peut comprendre, coaxialement à ladite partie optique commune, et en amont de celle-ci, un canon à électrons, suivi d'une lentille magnétique de réglage du diamètre de la sonde électronique.

Typiquement, l'énergie des électrons primaires est de l'ordre de 30 keV.

Dans une variante de l'invention, l'échantillon étant isolant, l'énergie des électrons primaires est réduite de telle sorte que ceux-ci puissent se réfléchir au voisinage de la surface avec une énergie quasiment nulle. Cette disposition est de nature à éliminer les effets de charge dus au bombardement ionique (demande de brevet français 83 00 538).

Dans une autre variante, l'énergie des électrons primaires est de l'ordre de 100 keV, l'échantillon étant mince et observé par transmission.

Enfin, l'appareil comprend, de préférence, à partir de l'extrémité de la partie commune opposée à l'échantillon, un autre secteur électrostatique qui reprend les électrons secondaires pour les amener sur un détecteur.

D'autres caractéristiques et avantages de l'invention apparaîtront à l'examen de la description détaillée ci-après, ainsi que des dessins annexés, sur lesquels:

- la figure 1 est un schéma de principe d'un appareil selon l'invention;
- la figure 2 est un autre schéma de principe du même appareil auquel sont ajoutés les auxiliaires électroniques de celui-ci;
- la figure 3 est un schéma optique détaillé de l'appareil selon l'invention;
- les figures 4A et 4B sont deux schémas optiques détaillés du même genre, mais comportant en outre la représentation des points images et des pupilles relatives aux ions primaires positifs;
- les figures 5A et 5B sont d'autres schémas détaillés illustrant respectivement le principe du balayage des ions primaires et des ions secondaires;
- la figure 6 est le schéma détaillé d'une optique rapprochée qui fait partie de l'appareil;
- les figures 7A et 7B sont des schémas optiques détaillés de l'appareil, montrant respectivement les images et les pupilles relatives aux ions secondaires négatifs;
- les figures 8, 8A et 8B et 8C sont des schémas simplifiés permettant de mieux comprendre le fonctionnement de l'appareil selon l'invention, en sa partie ionique;
- les figures 9 et 9A sont également des schémas optiques simplifiés, mais relatifs à l'optique rapprochée associée à l'optique de mise en forme;
- la figure 10 illustre la séparation des ions primaires et des ions secondaires;
- la figure 11 illustre les fonctionnements achromatiques des déviateurs des faisceaux ioniques, primaire et secondaire, compte tenu du séparateur de ces deux faisceaux;
- la figure 12 illustre les effets de dispersion chromatique dus à une déflexion des ions; et
- les figures 13A et 13B illustrent respectivement les trajectoires des électrons primaires et des électrons secondaires dans le schéma optique détaillé de l'appareil, limité à sa partie axiale.

Les dessins annexés comportent de nombreux éléments de caractère certain qu'ils peuvent seuls apporter. Ils font donc partie intégrante de la description, pour servir à faire comprendre l'invention, aussi bien qu'à la définir.

Les figures 1 à 3 montrent que l'appareil décrit comporte une source d'ions S10, et un spectromètre de masse SP20, précédé d'une optique de transfert 021.

Dans un mode de réalisation préférentiel de l'invention, la source d'ions est celle décrite dans la Demande de Brevet français N° 84 07 606, déposée le 16 mai 1984 et intitulée "Source d'ions opérant par ionisation de surface, notamment pour la réalisation d'une sonde ionique". Pour leur part, le spectromètre de masse et son optique de transfert sont ceux décrits dans la Demande de Brevet français N° 84 01 332, déposée le 27 janvier 1984, sous le titre: "Spectromètre de masse, à grande clarté, et capable de détection multiple simultanée". Les contenus de ces deux Demandes de brevet antérieures sont incorporés à la présente description, pour compléter la description et la définition de l'invention.

Par ailleurs, la présente invention fait intervenir des faisceaux d'ions et d'électrons. Par une extension classique, on utilise le mot optique pour les organes travaillant sur ces faisceaux à la manière de l'optique photonique traditionnelle. Il est alors rappelé que l'optique des ions utilise essentiellement des moyens électrostatiques; celle des électrons primaires se fera principalement à l'aide de champs magnétiques (moyens magnétiques ou électromagnétiques); quant aux électrons secondaires, d'énergie moindre, ils subissent aussi l'action des moyens électrostatiques.

**Description d'ensemble**

L'appareil selon l'invention (figures 1 à 3) est entouré d'une enceinte EN, dans laquelle on fait un vide poussé par des pompes cryogéniques PC1 et PC2.

Un porte-objet PO, réglable, supporte un échantillon EC, afin de pouvoir le déplacer parallèlement à sa surface libre.

Au centre, perpendiculairement à la surface de l'échantillon, l'appareil est agencé à la façon d'une colonne de microscope électronique à balayage.

Selon une caractéristique importante de l'invention, cette colonne présente une partie optique commune, et coaxiale, pour les faisceaux d'ions et d'électrons primaires et secondaires. Notée 5 sur la figure 1, cette partie s'étend jusqu'à l'échantillon, lequel contribue à ses propriétés optiques.

Pour clarifier l'exposé, on admet tout d'abord que les ions primaires sont positifs (de préférence $Cs^+$ ou $K^+$). Les ions secondaires sont en principe négatifs. L'impact des ions primaires crée aussi des électrons secondaires. Enfin, un faisceau électronique primaire (microsonde électronique), frappant la même zone de l'échantillon que le faisceau ionique primaire (microsonde ionique) va lui aussi faire naître des électrons secondaires. Dans ces conditions (figure 1):

- les ions primaires émis par la source d'ions S10 sont amenés sur l'échantillon par des premiers moyens optiques électrostatiques, notés globalement 1, et incorporant la partie optique commune 5;
- les ions secondaires éjectés par l'échantillon EC sont amenés au spectromètre de masse SP20 par de seconds moyens optiques électrostatiques 2, incorporant la partie optique commune 5;
- des électrons primaires sont produits par un canon à électrons S30, suivi d'une optique R31 pour le réglage de la géométrie du faisceau d'électrons, notamment son diamètre. Ces électrons primaires vont vers l'échantillon à travers la partie optique commune 5;
- enfin les électrons secondaires émis par l'échantillon EC traversent aussi la partie optique commune 5, pour être repris par un organe de détection D40 à leur sortie de celui-ci.

Il apparaît immédiatement que les fonctions demandées à la partie optique commune 5 sont délicates, car elle doit:

- assurer des fonctions optiques pour les quatre faisceaux ioniques et électroniques, primaires et secondaires, et ce, de manière à la fois compatible et réglable indépendamment;
- permettre ces fonctions alors que les faisceaux ioniques et électroniques sont assujettis à des balayages et des corrections synchrones; et
- réaliser tout cela en respectant l'objectif d'avoir une sonde petite, c'est-à-dire fine, en même temps qu'une collecte grande, c'est-à-dire très efficace, des ions secondaires.

Pour cela, il est tout d'abord prévu que le point d'entrée (point haut, la colonne étant supposée verticale) de la partie optique commune 5 est un centre de pivotement du balayage ionique primaire (B13). Par contre, le balayage des électrons primaires s'effectue dans un organe B56 incorporé dans la partie optique commune.

De préférence, l'appareil est replié sur lui-même. A cet effet, les ions primaires sont déviés sur un peu moins de 180° par un déviateur D12, avant d'arriver sur leur organe de balayage B13. La déviation est complétée à 180° par des plaques électrostatiques B543 (figure 3) faisant partie d'un organe combinateur-séparateur de faisceaux CS54, qui constitue l'extrémité haute de la partie optique commune 5.

Réciproquement, en sortie de l'organe CS54, les ions secondaires entrent dans leur dispositif de correction dynamique synchrone des effets du balayage primaire B23, puis dans un déviateur D22, qui complète la déviation des ions secondaires à 180°, tout en réalisant un filtrage d'énergie (Fe22) (figure 3).

Du côté primaire, les premiers moyens optiques électrostatiques comportent alors en tête une optique R11 pour le réglage du faisceau ionique primaire, placée entre la source S10 et le déviateur D12.

Du côté secondaire, les seconds moyens optiques électrostatiques se terminent par une optique 021 pour le transfert des ions secondaires de la sortie du déviateur D22 au spectromètre de masse SP20.

**Description d'un mode de réalisation particulier (ions primaires positifs).**

*La microsonde ionique (Moyens optiques 1)*

La source d'ions S10 est une source d'ions Césium $Cs^+$, telle que décrite dans la Demande de Brevet 8 407 606, en sa version riche en ions sur l'axe, avec une énergie nominale de 10 keV.

L'optique de réglage R11 comprend d'abord trois lentilles électrostatiques L110, L111 et L112, montées en cascade, et polarisées positivement. Centrées sur l'axe de la source, elles en forment des images réduites I1 - P et I2 - P (figure 4A). Viennent ensuite des plaques de centrage B0113, et un correcteur d'astigmatisme CA114, réglé pour être efficace jusqu'à l'échantillon.

Le faisceau ionique primaire entre alors dans le premier secteur électrostatique sphérique S121 du déviateur D12. Après une déviation de 90°, l'image de la source se trouve en I3 - P (figure 4A). Une lentille électrostatique L123 amène maintenant le faisceau ionique à un second secteur électrostatique sphérique S122, qui opère sur 84°. A sa sortie, qui donne une image I4 - P, le faisceau est dirigé vers le centre de pivotement des plaques B543, qui l'amène, par une déviation complémentaire de 6°, dans l'axe optique de la partie optique commune 5.

La lentille L123 a pour fonction de combiner les focales achromatiques de S121, S122 et B543, de sorte que la déviation globale de 180° produite par ces optiques soit insensible, au premier ordre, à des variations éventuelles de la tension d'accélération des ions du côté de la source, de la dispersion énergétique initiale des ions, et / ou des tensions alimentant les secteurs électrostatiques (qui sont de préférence les mêmes pour les deux secteurs). Il est en outre possible de filtrer en énergie le faisceau primaire à l'aide d'une fente de filtrage non représentée.

Entre S122 et B543, mais hors de l'axe de la partie optique commune, le balayage B13 des ions primaires est réalisé par deux couples de plaques en cascade, B131 et B132, qui font pivoter le faisceau pratiquement autour du centre de pivotement de B543 (figure 5A). Le balayage obtenu sur l'échantillon est de l'ordre de la dizaine de micromètres.

Le long de la partie optique commune 5, et après les plaques B543, les ions primaires rencontrent essentiellement la lentille électrostatique L554, polarisée positivement, qui fait partie d'une optique de mise en forme MF55, et l'optique rapprochée OR57, qui fait partie de l'ensemble terminal de focalisation/collecte FC57. Les autres organes de la partie optique commune ont peu ou pas d'effet sur le faisceau d'ions primaires.

La lentille L554 donne de l'image I4 - P une avantdernière image I5 - P. L'optique rapprochée OR57 détermine l'image réduite finale sur la surface de l'échantillon. La figure 4A montre ces images. La figure 4B vient la compléter, en illustrant les points CO1 - P à CO6 - P dits de "cross-over" (pupilles d'éclairement). Il s'agit des points où les trajectoire d'ions issus de la source parallèlement à son axe optique vont par la suite couper cet axe optique. Ces points, et les trajectoires qui les rejoignent, sont importants pour l'obtention d'une optique satisfaisante.

*Optique rapprochée OR57*

La figure 6 montre plus en détail l'optique OR57. Elle comprend un diaphragme D570 et des électrodes L572 à L575 de diverses polarités.

L'électrode L572 est mise à la masse. Les électrodes L573 et L575 sont polarisées au même signe que l'échantillon, qui est opposé au signe des ions primaires. Seule l'électrode L574 est polarisée au même signe que les ions primaires.

Ainsi, lorsque les ions primaires sont positifs, l'échantillon EC, l'électrode L575 et l'électrode L573 sont polarisés négativement, tandis que l'électrode L574 l'est positivement.

L'électrode L554 forme une image du centre de pivotement (en B543) au centre du diaphragme D570, lequel sert aussi de diaphragme d'ouverture pour le faisceau d'ions primaires FP.

La disposition adoptée pour le balayage du faisceau d'ions primaires permet d'effectuer ce balayage autour dudit centre de pivotement sans agir sur le faisceau d'électrons primaires, ni sur les faisceaux secondaires. Toutefois, ce balayage s'effectue à un niveau où l'image de la source n'est pas encore suffisamment réduite, de sorte que la réduction ultérieure aura aussi pour effet de réduire l'amplitude du déplacement de la microsonde ionique sur l'échantillon (± 10 μm).

Enfin, l'ajustage final de la focalisation sur l'échantillon se fait avec l'électrode positive L574 de l'optique rapprochée OR57. Et cette focalisation peut être corrigée de façon dynamique en modulant la polarisation de L574 en synchronisme avec le balayage, de telle sorte que l'image de la source d'ions soit constamment au point sur la surface de l'échantillon, quelle que soit la position de la sonde.

On note enfin que la distance frontale de l'optique rapprochée de l'échantillon est très courte. La construction ramassée à l'extrême de l'optique OR57 confère des coefficients d'aberration assez faibles à la dernière lentille réductrice de la sonde ionique: une vingtaine de millimètres pour les coefficients Cc d'aberration chromatique et Cs d'aberration d'ouverture (ou sphérique).

Il en résulte la possibilité de limiter les tensions d'accélération et l'énergie V1 des ions primaires et de travailler avec une source de brillance moyenne sans nuire de façon rédhibitoire à l'intensité transportée par la sonde ionique. A partir d'une valeur V1 = 10 keV, l'optique rapprochée OR57 va porter les ions primaires à une énergie d'impact de 15 keV.

On reviendra plus loin sur ces questions, après avoir traité plus en détail des aberrations.

On remarquera maintenant que l'optique OR57 comporte, très près de l'échantillon EC et au même potentiel que lui, une électrode annulaire L575 (analogue du Wehnelt d'un canon à électrons). La partie cachée de l'échantillon EC par cette électrode n'aura aucune influence sur les champs électriques régnant du fait de l'électrode L574 (potentiel de l'autre polarité) de sorte que le mouvement de l'échantillon peut se faire sans perturber les focalisations des ions primaires ou secondaires.

*Extraction des ions secondaire*

Quant aux ions secondaires (négatifs), il résulte de ce qui précède que leur énergie V2 après accélération sera d'au plus 5 keV, sous l'effet de la différence de potentiel entre l'électrode L572 et l'échantillon.

La position de l'électrode L574 près de l'échantillon, et sa polarité par rapport à celui-ci, offrent l'avangage de créer un champ extracteur élevé au niveau de la surface de l'échantillon. Ce champ est un peu atténué par la présence de l'électrode L575, mais celle-ci introduit une courbure des équipotentielles qui est favorable à la focalisation des ions secondaires.

Cette focalisation est réalisée par l'électrode L573, compte tenu de l'effet des autres lentilles, de sorte que les trajectoires des ions secondaires émis dans un angle solide de $2\pi$ stéradians par un point de la surface de l'échantillon EC vont se recouper dans le plan du diaphragme D570, aux aberrations près.

L'image ionique secondaire I1 - S (figures 7A et 7B), ainsi formée dans le plan du diaphragme D570, a un grandissement de l'ordre de l'unité. Les ions secondaires peuvent alors franchir ce diaphragme sans atténuation quel que soit le point émissif de l'air balayé par la microsonde ionique, dès lors qu'il n'est pas trop éloigné de l'axe.

Il a été observé que l'intensité dans une sonde donnée dépend du diamètre de D570; à son tour, le nombre de pixels, ou éléments d'image, que l'on peut acquérir (avec des fluctuations statistiques acceptables) dans un temps donné, dépend de l'intensité de la sonde.

Ce nombre de pixels dépend donc du diamètre du diaphragme D570. Or il est également relié, pour une taille donnée de sonde, à la superficie du champ balayé sur l'échantillon. Et cette superficie est limitée par le diamètre du diaphragme D570. Il est à noter que l'image d'un point émissif est fortement aberrante et qu'elle se trouve dans le plan de ce diaphragme.

Ce n'est donc que dans la mesure où les aberrations ne remplissent pas toute la surface ouverte du diaphragme D570 que l'on peut balayer la sonde sans introduire de vignettage (assombrissement de l'image sur les bords du champ) dans les images électroniques et ioniques secondaires résultant du bombardement ionique.

Pour des particules secondaires dont l'énergie initiale (à l'éjection) n'excède pas une vingtaine d'électron-volts, les aberrations sont nettement inférieures au diamètre du diaphragme D570, même aux plus petites valeurs de celui-ci, qu'on utilise pour produire les sondes les plus fines (car alors le champ balayé est aussi plus petit).

Au-delà de 20 eV pour l'énergie initiale, il faut tenir compte de la bande passante énergétique ou chromatique du spectromètre de masse, ainsi que des atténuations diverses liées à l'acceptance limitée de celui-ci.

L'homme de l'art comprendra que l'optique rapprochée OR57, qui résoud les problèmes décrits ci-dessus, est un élément essentiel de l'invention.

*La microsonde ionique et les aberration optiques.*

Les figures 8, 8A et 8B schématisent les premiers moyens optiques électrostatiques 1, en les assimilant à une seule lentille électrostatique L, assortie d'un diaphragme Do.

La sortie de la source d'ions est une striction So de diamètre do. L'énergie cinétique desions primaires est V, avec une dispersion (chromatique) $\pm\ \delta V$. On définit pour une source thermique à ionisation de surface une brillance moyenne B qui s'écrit, de manière approchée:

$$(Jo / \pi)\ (V / \Delta V)$$

où Jo est le courant émis par l'unité de surface de l'ioniseur, et $\Delta V = 2.\ \delta V$.

Le diaphragme Do délimite un demi-angle d'ouverture "objet" $\alpha o$, tandis que $\alpha i$ et di notent le demi-angle d'ouverture et le diamètre gaussien de la sonde du côté "image" de la lentille L.

Si V0 et Vi désignent l'énergie des ions dans les espaces objet et image, respectivement, l'invariant optique s'écrit:

$$\sqrt{Vo}.\ do.\ \alpha o = \sqrt{Vi}.\ di.\ \alpha i$$

Le grandissement angulaire est $MA = \alpha i / \alpha o$, et le grandissement linéaire (en fait une réduction) est $ML = di / do$.

Pour $Vi = Vo$, on a $MA.ML = 1$.

*Aberration d'ouverture*

L'aberration d'ouverture est principalement une aberration de sphéricité (figure 8A), caractérisée par un diamètre $d_s$ à l'intersection d'une courbe du type caustique avec les limites d'ouvertures du faisceau ($\pm\ \alpha i$). On a:

$$ds = \frac{1}{2} ML.\ Cs.\ \alpha o^3$$

où Cs est le coefficient d'aberration sphérique, qui peut s'écrire:

$$Cs = Cs_0 + Cs_1 \cdot \frac{1}{ML} + Cs_2 \left(\frac{1}{ML}\right)^2 + Cs_3 \left(\frac{1}{ML}\right)^3 + Cs_4 \left(\frac{1}{ML}\right)^4$$

Les coefficients $Cs_j$ (j = 0 à 4) ne dépendent que des caractéristiques géométriques et électriques de la lentille L. En fonction de j, et pour Vi = Vo, il vient, lorsque ML << 1:

$$ds = \frac{ML^4 \cdot Cs}{2} \alpha i^3 \simeq \frac{Cs_4 \cdot \alpha i^3}{2}$$

Cette relation servira à déterminer l'aberration d'ouverture des lentilles de l'optique ionique primaire 1 (dans la mesure où la condition Vi = Vo est satisfaite).

Pour la lentille L574 de l'optique rapprochée OR57, Vo (10 keV) est inférieur à Vi (15 keV). C'est alors le coefficient $Cs_4(Vi / Vo)^{3/2}$ qui intervient et non $Cs_4$ seul.

*Aberration chromatique*

La figure 8B illustre l'aberration "chromatique". S'i, Si et S"i sont les images de So pour les énergies V - $\delta$V, V et V + $\delta$V, respectivement. Le diamètre tache d'aberration chromatique (au niveau de S) est donné par

$$dc = Cc.\ \alpha i \cdot \frac{\Delta}{V} \text{ avec } \Delta V = 2.\ \delta V$$

Il est alors associé à la sonde un diamètre "réel" d qui s'écrit

$$d^2 = dg^2 + ds^2 + dc^2$$

où dg est le diamètre gaussien en l'absence d'aberrations. Pour un diamètre d choisi, il a été observé qu'existe un couple de valeurs (dg, $\alpha$i) pour laquelle l'intensité de la sonde passe par un maximum, que l'on cherchera à atteindre. Et ce maximum sera d'autant plus élevé que l'on aura mieux réduit les coefficients d'aberration $Cs_4$ et Cc, en particulier par l'usage de lentilles de courte focale.

A propos de l'optique rapprochée OR57, on remarquera que:

- la distance frontale entre l'échantillon EC et l'électrode L574 étant faible, il en est de même pour les aberrations sur le faisceau primaire, et l'intensité dans la sonde peut être accrue;
- le champ électrique accélère ou ralentit le faisceau primaire suivant l'endroit considéré, mais ne le dévie pas, ce-qui élimine des risques d'instabilité sur la position de la sonde;
- il en serait différemment avec un faisceau primaire incliné sur l'objet, qui produirait de plus un effet d'ombrage.

*Correction dynamique de défocalisation*

Simplifiée comme les figures 8 à 8B, la figure 8C illustre la correction dynamique effectuée par la lentille proche de l'échantillon. Il est rappelé qu'une image du centre de pivotement du faisceau primaire est établie au niveau du diaphragme D570 (Do sur le schéma de la figure 8C).

A raison du balayage (figure 8C) et de l'aberration de courbure de champ de la lentille, la sonde explorerait non pas une surface plane, mais bien une calotte sphérique, illustrée ici tangente à l'échantillon EC.

La polarisation de l'électrode de commande de la lentille L de la figure 8C (L574) dans l'appareil (figure 6), est ajustée en fonction du balayage, de sorte que la sonde soit focalisée sur la surface plane de l'échantillon EC quelle que soit l'amplitude du balayage.

*Optique ionique secondaire (Moyens optiques 2)*

A leur départ de la surface de l'échantillon EC, les ions secondaires ont des énergies comprises entre zéro et une centaine d'électron-volts, avec une distribution qui présente un maximum vers 5 à 10 eV. Les directions d'éjection sont distribuées sur un angle solide de $2\pi$ stéradians, très approximativement selon une loi en cosinus, centrée sur l'axe.

Dans l'optique OR57, l'électrode L574 est par exemple à environ +15 kV par rapport à l'échantillon EC.

Le champ électrique d'accélération qui en résulte pour des ions secondaires négatifs contrarie la divergence naturelle des trajectoires initiales de ces ions et réduit, en valeur relative, leur dispersion énergétique initiale. Il leur communique une énergie cinétique (5 keV pour des ions monochargés à la sortie de L572), qui est beaucoup plus grande que leur énergie initiale moyenne. A cet égard, l'échantillon BC est partie intégrante de l'optique rapprochée 57. On admet pour simplifier que la surface émissive de l'échantillon EC (supposé conducteur) est plane et équipotentielle.

La figure 9 est un schéma simplifié où l'on a réuni en 57 l'optique de collecte FC57 et l'optique de mise en forme 55, tandis que deux plaques de balayage représentent le dispositif B543. A cette optique de collecte, on associe les deux éléments optiques particuliers que sont la pupille d'éclairement ou "cross-over" et l'image, qu'elle crée.

Quel que soit le point émissif, les trajectoires normales à la surface de l'échantillon vont couper le même point de l'axe optique. C'est le "cross-over", avec lequel il est avantageux de faire coïncider le centre de pivotement de la correction dynamique sur les ions secondaires (plaques B234 et B235). L'image est par contre un peu plus loin (voir figure 9, ainsi que C03 - S et I3 - S, figures 7A et 7B).

Pour la fonction de collection d'une microsonde ionique à balayage, il suffit ici simplement de récupérer les ions secondaires. Le "cross-over" n'a pas besoin d'être limité en diamètre pour obtenir une localisation fine du point émissif (comme c'est le cas pour le microscope ionique). L'image d'un point objet (A ou B) est alors tellement entachée d'aberrations que la notion même d'image n'est plus adéquate pour décrire précisément la structure du faisceau.

Si, par exemple, on se limite aux trajectoires méridiennes issues d'un point-objet, on peut utiliser une représentation où l'on porte en abscisse et en ordonnée la distance r et la pente r' des trajectoires à l'aplomb d'un point donné de l'axe optique (figure 9A).

Pour une optique parfaite, on obtiendrait une droite passant par l'origine. Sur la figure 9A, cela est vrai pour 2,5 eV. Par contre, dès que l'énergie initiale s'élève, les écarts produits par les aberrations d'ouverture sont d'autant plus élevés que l'énergie est plus grande (courbe 20 eV sur la figure 9B), c'està-dire que les ions ont des trajectoires qui s'écartent de plus en plus de l'axe.

De leur côté, les défauts chromatiques de l'optique de collecte se traduisent par des pentes à l'origine différentes pour chaque énergie.

L'homme de l'art aura compris que, si la première image ionique secondaire (I1 - S, figure 7A) ne permet pas d'obtenir la localisation spatiale de l'émission, celle-ci est néanmoins acquise en localisant le bombardement primaire sur l'échantillon.

Dans la partie optique commune 5, les lentilles L576 et L555 (figure 3) forment des images intermédiaires I2 - S et I3 - S (figure 7A). Leur rôle est notamment d'éviter que le faisceau d'ions secondaires ne s'écarte trop de l'axe optique avant d'atteindre les plaques B543, en particulier lorsque le point émissif est situé loin de l'axe, comme cela se produit au cours du balayage de l'échantillon sur de grands champs.

Dans l'optique de mise en forme MF55, la lentille L554, polarisée positivement, exerce une action convergente faible.

Les travaux menés ont montré par ailleurs ce qui suit:

- le faisceau d'ions secondaires issu de l'aire d'impact, après mise en forme, doit présenter une structure compatible avec l'acceptance du spectromètre de masse SP20, dont le pouvoir séparateur est élevé;
- mais il y a lieu d'accomoder une large bande d'énergies initiales. De plus,les trajectoires issues de l'aire d'impact se répartissent sur un "cross-over" étendu, et sur une image empâtée d'aberrations assez grandes. Le faisceau issu d'un point couvre alors toute l'étendue géométrique acceptable par le spectromètre;
- en conséquence, le faisceau issu d'un point voisin, lors du balayage, n'entrerait pas tout entier dans le spectromètre.

Pour résoudre ce problème, il est prévu, selon l'invention, que le faisceau ionique secondaire est lui aussi soumis à un balayage, dénommé correction dynamique synchrone, ainsi que cela transparaissait ci-avant.

La figure 10 illustre le principe de la séparation des faisceaux ioniques primaire FP et secondaire FS au niveau des plaques B543.

La figure 11 le montre en plus de détails. Comme l'énergie est à ce niveau V1 = 10 keV pour les ions primaires contre V2 = 5 keV pour les ions secondaires, les remiers sont déviés de 6° lorsque les seconds le sont dé 12°.

Dans l'exemple décrit, les ions primaires sont $Cs^+$ ou $K^+$, et les ions secondaires négatifs, étant observé que l'implantation de Césium ou de potassium favorise l'émission d'ions négatifs. Inversement, des ions primaires $I^-$ feraient de même pour les ions secondaires positifs. Le séparateur opère dans les deux cas, et même si l'on échange les énergies des ions primaires et secondaires (V1 = 5 keV; V2 = 10 keV).

Il est à noter aussi que les plaques B543 permettraient de séparer des ions de même signe, qui seraient alors déviés dans le même sens.

En aval des plaques B543, le faisceau d'ions secondaires pointe vers le déviateur D22, qui est semblable au déviateur D12 (figures 1 à 3).

Toutefois, son premier secteur électrostatique sphérique S223 n'opère que sur 78° (figures 3 et 11). Il est couplé par la lentille L227 au second secteur S224, qui fonctionne sur 90°.

A ce niveau,il faut résoudre le problème lié à la forte dispersion énergétique que présentent les ions secondaires: toute déviation électrostatique s'accompagne d'une dispersion énergétique, car l'angle de déviation dépend de l'énergie des particules.

La figure 12 montre deux trajectoires écartées d'un angle αc, dû au fait qu'elles correspondent à des énergies V2 et V2 + v. La trajectoire "V2" est inclinée de θ sur l'axe à partir du centre de pivotement F'c. On peut écrire:

$\alpha c \simeq \theta \cdot \dfrac{v}{V2}$ lorsque l'angle θ est petit. Dans le cas du secteur sphérique S224 qui assure une déviation de 90°, $\alpha c \simeq \dfrac{v}{V2}$.

Inversement, si l'on fait converger vers Fc (figure 11) un faisceau dispersé en énergie avec des angles $\alpha c$ appropriés, l'axe du faisceau sortira en suivant un rayon unique. La dispersion chromatique est annulée.

Ainsi, selon l'invention, la lentille L227 est placée de sorte qu'elle conjugue la focale achromatique résultant des actions combinées de B543, de S223 et du secteur S224, en donnant le grandissement angulaire propre à annuler les effets chromatiques à la sortie de S224, tout au moins au premier ordre.

Il est rappelé que, lorsque la sonde balaie la surface de l'échantillon, l'axe du faisceau secondaire pivote autour de son "cross-over" (C01 - S, figure 7B). Il en est de même pour les images de celui-ci CO2 - S, CO3 - S (figures 5B, 7B, 11).

La correction dynamique synchrone sur le faisceau secondaire est définie par les deux paires de plaques B234 et B235 (figure 3). Ces deux plaques sont disposées de telle sorte que le centre de pivotement résultant de leur action combinée se trouve en (CO3)', image de CO3 - S donnée par les plaques B543 (figure 11).

Il suffit alors d'appliquer aux plaques B234 et B235 des tensions synchrones de celles appliquées aux plaques B131 et B132 du faisceau primaire, respectivement, de façon à annuler la rotation autour de (CO3)'.

Le faisceau secondaire reste ainsi stationnaire dès son entrée dans le déviateur D22. Et le spectromètre de masse SP20 va alors recevoir un faisceau secondaire présentant toujours les mêmes caractéristiques géométriques quel que soit le point balayé.

Entre temps, une fente de filtrage en énergie FE22, placée au niveau du "cross-over" CO4 - S (figure 11), limite à l'intervalle [0 eV, 20 eV] la bande d'énergie transmise au spectromètre.

L'optique de transfert O21 et le spectromètre SP20 sont de préférence ceux décrits dans la Demande de Brevet français 8 401 332, avec les correspondances du tableau ci-après (voir aussi EP-A-0 151 078):

| La présente demande | La demande 8 401 332 |
|---|---|
| Lentille L218 | Lentille LE11 |
| Plaques B216 | Plaques PC12 |
| Lentille à fentes LF211 | Lentille à fentes LF13 |
| Lentille L219 | Lentille LE14 |
| Fente Fe21 | Fente FE20 |
| Post-accélération PA21 | Post-accélération PA21 |
| (non représenté) | Hexapôle HP22 |
| Spectromètre SP20 | Références 23 à 25 (précédées éventuellement de lettres) |

En bref, les lentilles L218 et L219 coopèrent pour produire une striction du faisceau au niveau de la fente FE21, qui est la fente d'entrée du spectromètre. Les plaques B216 centrent le faisceau. La lentille à fentes LF211 rend le faisceau parallèle, en section verticale, au niveau de la fente d'entrée Fe21. Une post-accélération peut être prévue, pour certaines applications.

**Moyens d'observation électronique**

Il reste à considérer les faisceaux électroniques, qui vont permettre une observation de l'échantillon par un moyen autre que la microsonde ionique, et complémentaire de celui-ci à de nombreux titres.

Dans le mode de réalisation considéré jusqu'à présent, on opère en microscopie électronique à balayage, avec réémission d'électrons secondaires.

*La microsonde électronique*

Le faisceau d'électrons primaires, d'une énergie de 30 keV par exemple, est amené par la lentille magnétique M31 dans l'axe des plaques B543 du combinateur-séparateur CS54. Au champ électrique dû à ces plaques est superposé un champ magnétique perpendiculaire au plan de la figure (figures 3, 13A, 13B).

Ce champ magnétique est ajusté, compte tenu de l'énergie des électrons primaires, pour compenser exactement la déviation que le champ électrique produirait sur eux s'il agissait seul. Les électrons primaires continuent donc en ligne droite.

On note immédiatement, qu'en sens inverse, les électrons secondaires, d'énergie différente, seront par contre déviés vers un dispositif de détection D40 comprenant un secteur électrostatique S405 suivi d'un détecteur D406 figure 13B), par exemple du type multiplicateur d'électrons type X919AL commercialisé par R.T.C. Une variante plus élaborée consiste à post-accélérer les électrons secondaires et à utiliser, comme détecteur, un scintillateur. Une étape supplémentaire peut être franchie en modifiant la structure du faisceau électronique de telle sorte que l'on ait accès à une image réelle du "cross-over". On peut alors se donner les moyens d'utiliser, si on le désire, une partie seulement du "cross-over" (ou encore deux ou plusieurs parties différentes, en parallèle dans deux ou plusieurs voies distinctes de détection) pour modifier le contraste de l'image électronique ou faire apparaître des contrastes nouveaux. En effet, le "cross-over" contient toute l'information sur la distribution angulaire initiale des électrons. Prélever une partie du "cross-over" revient donc à privilégier un angle solide d'émission qui est plus ou moins rempli selon, par exemple, le relief de la surface ou encore les petites hétérogénéités locales de champs électrique ou magnétique liées à la structure même de l'échantillon: le contraste évolue avec la zone prélevée sur le "cross-over". Collecter en parallèle deux zones distinctes du "cross-over" permet d'effectuer un traitement de l'image afin de mieux distinguer les sources du contraste.

Quant au faisceau d'électrons primaires, la lentille magnétique M552 assure, compte tenu de la présence de lentilles électrostatiques, son transfert vers une ultime lentille magnétique réductrice M571. Dans le plan principal objet de celle-ci, le diaphragme D570 limite l'ouverture du faisceau d'électrons primaires. En effet, un diaphragme conducteur amagnétique peut être immergé dans le champ magnétique de la lentille, pour limiter l'ouverture, sans en perturber la focalisation. (Il en est différemment avec les lentilles électrostatiques).

Entre M552 et M571, un système B56 de bobines (essentiellement quatre bobines B56a et quatre B56b, disposées deux à deux dans deux plans orthogonaux) assure le centrage, le balayage de la sonde électronique, la correction d'astigmatisme étant assurée par huit bobines (non visibles) disposées à mi-distance des bobines B56a et B56b. Le champ magnétique de ces bobines n'a pratiquement pas d'influence sur les trajectoires des ions primaires et secondaires.

Ainsi, on peut analyser le même échantillon avec une microsonde ionique, et l'examiner avec un microscope électronique de résolutions comparables, pouvant descendre jusqu'à une dizaine de nanomètres.

*Collection des électrons secondaires*

Il en résulte un faisceau d'électrons secondaires réémis lorsque l'échantillon est polarisé négativement (cas des ions primaires positifs).

L'optique rapprochée OR57 devrait alors extraire ces électrons secondaires pour les accélérer sensiblement comme les ions secondaires négatifs (même énergie, avec cependant moins d'aberration chromatique). Il est rappelé qu'une première image ionique secondaire I1 - S est formée près du diaphragme D570 (figure 7A).

Mais ce diaphragme est immergé dans le champ magnétique de la lentille M571 et placé dans le plan principal objet de celle-ci (pour les électrons primaires). De plus:

- cette lentille M571 exerce une action focalisante bien plus forte sur les électrons secondaires (5 keV) que sur les électrons primaires (30 keV);
- le champ de fuite de la lentille magnétique M571 atteint l'échantillon EC, et pénètre par ailleurs la lentille électrostatique L576 (figure 3);
- enfin, l'optique magnétique fait tourner les images électroniques autour de l'axe optique.

Les images ionique (I1 - S, figure 7A) et électronique (I'1 figure 13B) ne sont donc ni superposables, ni situées exactement au même endroit.

Il s'est avéré possible de résoudre d'une manière satisfaisante ce problème en agissant sur la polarisation de l'électrode L573, pour mettre l'image électronique I'1 dans le plan du diaphragme D570 sans que l'image ionique I1 - S ne s'en éloigne au point d'introduire un effet de vignettage.

Par la suite, les images ionique et électronique se séparent nettement (comparer I2 - S figure 7A à I'2 figure 13B).

Les électrons secondaires rencontrent d'abord les bobines de balayage B56. La déviation qui leur est ici imprimée est environ 2,5 fois plus élevée que pour les électrons primaires. Un compromis peut être obtenu en établissant la distance à l'égard de l'échantillon de sorte que l'image ait tourné de 90° au niveau des bobines. Les lentilles L576 et L555 permettent alors de mettre en forme le faisceau d'électrons secondaires pour qu'il traverse les lentilles L554 et M552 sans atténuation, par perte d'électrons trop éloignés de l'axe. Ainsi, on retrouve une image électronique secondaire I'3 au niveau de la lentille M552.

Séparés par l'organe CS54, les électrons secondaires vont enfin être détectés, comme précédemment décrit, afin de créer une image électronique vidéo ou non en synchronisme de leur balayage.

*Variantes de l'observation électronique*

Il est clair que si les électrons secondaires sont dus uniquement au bombardement ionique (pas d'électrons primaires obtenus par actionnement simultané du canon à électrons), les lentilles M571 et M552 de même que le balayage B556 peuvent être rendus inactifs. Les plaques B543 et le champ magnétique transverse suffisent alors à séparer ions et électrons secondaires.

Dans le cas où l'échantillon est mince, l'observation électronique de celui-ci peut se faire en microscopie électronique par transmission. L'énergie des électrons primaires est alors augmentée, par exemple portée à 100 keV. Un détecteur analogue à ceux connus en microscopie électronique par transmission (avantageusement d'un type propre à analyser les pertes d'énergie subies par les électrons) est alors logé derrière l'échantillon EC, dans le porte-objet PO. Les ions secondaires dûs à la microsonde ionique peuvent demeurer observables, comme précédemment décrit, avec les électrons secondaires que peut continuer à émettre l'échantillon sous l'effet du bombardement électronique primaire.

*Fonctionnement général de l'appareil.*

Il est important de noter que le choix des énergies d'accélération des diverses particules, joint à la différence de signe entre ions primaires et secondaires, permet de rendre le réglage de chaque faisceau quasiment indépendant de celui des autres.

En effet, les lentilles magnétiques du microscope assurent la focalisation des électrons primaires mais agissent très peu sur les faisceaux d'ions.

Les lentilles électrostatiques polarisées positivement agissent sur les ions primaires positifs, mais leur effet focalisant sur les ions secondaires négatifs (ou les électrons secondaires) est beaucoup plus faible; il est pratiquement négligeable sur les électrons primaires.

Les lentilles polarisées négativement agissent sur les ions secondaires négatifs et les électrons secondaires (accélérés avec la même énergie) mais assez peu sur les ions primaires positifs et pratiquement pas sur les électrons primaires car leur énergie est trop élevée (30 keV).

Lorsqu'on utilise des ions primaires négatifs et qu'on recueille des ions secondaires positifs, l'indépendance des réglages reste à peu près respectée. Par contre, dans ce cas, on ne peut pas obtenir simultanément une image ionique et une image en électrons secondaires car ces derniers sont retenus sur la cible par la polarisation positive. Pour observer les échantillons massifs, il reste toutefois la possiblité d'utiliser les électrons rétrodiffusés, leur énergie étant suffisamment élevée pour qu'ils échappent à l'attraction de l'échantillon.

Quant à l'examen des échantillons minces en micrescopie à transmission, il est toujours compatible avec l'obtention simultanée d'images en ions secondaires positifs ou négatifs.

Enfin, les effets de charge qui risquent d'apparaître sur les échantillons isolants lorsqu'on recueille les ions secondaires négatifs peuvent être éliminés grâce à une utilisation particulière du faisceau d'électrons primaires. Il suffit d'abaisser l'énergie de ces dernières à une valeur égale à 5 keV pour qu'ils se réfléchissent avec une énergie très faible au voisinage de la surface de l'échantillon. Il en résulte que les charges positives qui tendent à se développer sur l'isolant, entre autres à cause de l'émission électronique secondaire, se neutralisent automatiquement sans qu'un excès de charges négatives puisse se développer car le faisceau d'électrons serait alors automatiquement repoussé Demande de Brevet français 8 300 538).

*Auxiliaires électroniques de l'appareil*

Il est maintenant fait référence à la figure 2, pour la description des auxiliaires de l'appareil, lesquels permettent les fonctionnements exposés ci-dessus.

Un bloc AS30 réalise l'alimentation du canon à électrons, de manière connue.

Les lentilles du microscope électronique à balayage (M31, champ magnétique en B543, M552, M571) sont pilotées par une alimentation AM31.

Un bloc AD réalise l'alimentation en haute tension des déflecteurs achromatiques D12 et D22, ou plus exactement de leurs secteurs sphériques.

Un bloc ACS réalise l'alimentation et les réglages du séparateur de faisceau CS54, tandis qu'un bloc AMF réalise le contrôle de ce faisceau par leur optique de mise en forme MF55.

Le réglage du diamètre de la sonde ionique par R11 est sous le contrôle d'un circuit AR11, tandis que l'alimentation et les réglages propres à la source d'ions S10 sont permis par un circuit AS10.

Un circuit CG réalise le contrôle général du vide et des sécurités.

Un ordinateur ou unité centrale de traitement UCT, auquel est associée une mémoire de masse MEV, est prévu pour le rassemblement des mesures, et, de préference, pour assister les réglages produits par les autres circuits.

L'ordinateur pilote en tout cas un système de balayage d'images SBI, qui agit directement sur les balayages ioniques B13 et B23, sur le balayage électronique B56, et sur le mouvement du porte-objet PO. Indirectement, le système SBI agit sur l'électrode L574 (figure 6) de l'optique FC57 (figure 2) ou plus précisément OR57 (figure 3), afin de réaliser la focalisation dynamique. Cette action passe par un circuit de réglage de focalisation et de collecte AFC, qui pilote l'optique FC57, à l'exception de sa lentille magnétique.

Un organe CSM, sous le contrôle de l'ordinateur UCT, commande le spectromètre de masse SP20.

Les mesures issues de ce spectromètre SP20 et du détecteur d'électrons D40 sont reprises dans un circuit d'acquisition MAD, lequel influe sur le système de balayage SBI.

Enfin, l'ordinateur UCT regroupe ces mesures pour les ranger dans la mémoire de masse MEV, compte tenu du balayage.

**Mise en oeuvre pratique de l'appareil**

Certains autres aspects de l'invention seront maintenant décrits en prenant l'exemple d'une sonde ionique de diamètre 0,1 m et d'intensité égale à $7.10^{-12}$ A (sur l'échantillon).

*Influence du bruit d'émission*

Si un point-image ou pixel possède une taille égale au diamètre de la sonde, on peut déterminer qu'en $10^{-5}$ seconde, un pixel reçoit en moyenne n = 440 ions.

Avec un rendement de pulvérisation de matière égal à 5 atomes arrachés de l'échantillon par ion incident, l'irradiation de $10^{-5}$ sec. arrache une épaisseur de matière d'environ $5.10^{-3}$ nanomètres ou 0,05 Angström (côté destructif de l'analyse ionique).

Le rendement en électrons secondaires étant de l'ordre de 10 par ion incident, la détection du signal électronique issu d'un pixel pourra se faire, avec toutefois un bruit statistique de l'ordre de ± 5 %;

Dans ces conditions, obtenir une image en électrons secondaires qui se répète à la fréquence de télévision -25 images par seconde - implique que l'on se limite à un champ balayé de $N = 4.10^3$ pixels. Pour augmenter ce champ, il faut accroître l'intensité de courant dans la sonde.

Mais si l'on tient compte d'un contraste minimal observable C égal à K fois le bruit, il vient:

$$C = \frac{n2 - n1}{n} > K\sqrt{n}$$

où n2 et n1 sont les nombres d'ions incidents sur deux plages voisines et n le nombre moyen d'ions incidents. Si K = 5, n = 4.103 et n = 440 ions, l'image devra présenter à son émission des contrastes d'au moins 25 %. Ceci est vrai en vidéoscopie à 25 images / seconde, mais une pose d'une seconde suffira à observer des contrastes de 5 %.

De plus, l'image va évoluer sous l'effet de l'érosion ionique. On peut admettre que la topographie de l'échantillon ne va pas changer de façon perceptible avant l'arrachement d'une épaisseur de matière de l'ordre du tiers du diamètre de la sonde (soit 30 nanomètres ou 300 Angströms environ). Dans l'exemple donné, le temps caractérisitique d'évolution est alors de 4 minutes, ce qui est compatible avec l'observation de l'image électronique secondaire à la fréquence de télévision. L'utilisation du potassium réduirait la vitesse d'érosion de l'échantillon et augmenterait la durée d'observation.

Mais d'autres facteurs peuvent influer sur la qualité de l'image électronique, notamment:

- l'mplantation des ions primaires (césium) qui favorise l'émission électronique secondaire, cet effet peut varier d'un grain cristsallin à l'autre, et aussi au cours du régime transitoire d'émission électronique secondaire en fonction du bombardement par les ions primaires;
- cet effet peut aussi favoriser la fixation des molécules de gaz résiduel dans l'enceinte à vide, et influer par là sur le rendement de l'émmision électronique secondaire.

Pour sa part, l'image ionique secondaire (obtenue par balayage de l'échantillon avec la microsonde ionique) est plus exigeante, car un ion primaire incident crée moins d'ions secondaires que d'électrons secondaires. De façon générale, le rendement utile en ions secondaires - rapport du nombre d'ions arrivant sur le détecteur (spectromètre) au nombre d'atomes éjectés de la cible - dépend de la probabilité de formation des ions au cours du processus d'éjection et de l'efficacité de collecte du système extracteur couplé au spectromètre de masse.

Ainsi, avec un rendement moyen d'un ion secondaire pour 50 atomes éjectés, et une concentration atomique de 25 %, l'image obtenue en 1/25 seconde sur $4.10^3$ points / images avec la sonde de diamètre 0,1 micron possède en moyen 10 ions par pixel. Il en résulte un bruit statistique de ± 30 %.

La réduction de ce bruit nécessite l'érosion d'une épaisseur plus grande de matière pendant le temps d'acquisition de l'image, donc une sonde plus intense.

Avec une sonde 40 fois plus intense (pour la même dimension de pixel), on retrouverait la même statistique que sur l'image électronique en fréquence télévision, mais l'épaisseur érodée serait alors de 0.2 nm (2 Angströms) par image.

Pour conserver la même statistique avec la sonde initiale (0,1 micron, $7.10^{-12}$ Ampère et $5.10^{-3}$ nm (0,05 Angström) érodé par image), il faut réduire à 10 le nombre de pixels d'une image (à 25 images / seconde).

Mais l'invention apporte une possibilité différente:

- l'image en électrons secondaires (de cause ionique) permet de régler la focalisation de la sonde ionique à une fréquence vidéo (25 images / seconde);
- cela fait, il n'est plus du tout indispensable d'observer l'image ionique secondaire à la fréquence vidéo.

*Influence du bruit de détection*

Il faut encore tenir compte du bruit de fond du détecteur d'ions que constitue le spectromètre de masse.

Pour l'image ionique de $4.10^3$ pixels de 0,1 micron, on peut accumuler les données correspondant à l'érosion d'une épaisseur de 30 nm (300 Angströms) (en 4 minutes).

Au bout des 4 minutes, un élément présent à la concentration de 40 ppm aura produit une dizaine d'ions caractéristiques par pixel.

Si l'on admet 0,1 coup / seconde comme bruit de fond moyen du spectromètre, le bruit s'élèvera à environ 25 coups en 4 minutes. Le rapport du signal en ions secondaires sur le bruit dû à la détection est supérieur à $10^3$, ce qui est satisfaisant.

*Influence de la qualité du vide*

Reste enfin l'effet du gaz résiduel dans l'enceinte à vide. La présence de vapeur d'eau, d'oxyde de carbone et d'autres résidus peut induire, même à très basse pression, une émission d'ions $H^-$, $C^-$, $O^-$, $OH^-$, notamment.

Pour un vide de $6,6.10^{-7}$ pascal ($5.10^{-9}$ Torr), chaque micron carré de surface de l'échantillon EC reçoit

$1,5.10^4$ molécules par seconde.

Si toutes ces molécules se fixent sur la surface, et que leur rendement d'ionisation est le même que pour les atomes de l'échantillon, le rapport entre le nombre Nv d'atomes (d'oxygène par exemple) arrivant du gaz résiduel sur l'échantillon, et le nombre NA d'atomes éjectés par unité de temps s'écrit:

$$\frac{Nv}{NA} = \frac{1,5.10^4}{\rho \cdot \varepsilon} \simeq \frac{50p}{\varepsilon}$$

où ρ est la densité atomique de l'échantillon (nombre d'atomes par micron-cube, ε l'épaisseur érodée en microns par seconde, et p la pression partielle exprimée en Torr.

Dans l'exemple étudié ($p = 6,6.10^{-7}$ pascal ou $5.10^{-9}$ Torr, sonde de 0,1 micron sur $4.10^3$ pixels) on a $\varepsilon = 1,25.10^{-4}$ microns / seconde, d'où $Nv / NA \simeq 2.10^{-3}$.

L'apport du gaz résiduel est donc équivalent à une concentration de matière de 0,2 % dans l'échantillon, soit 50 fois plus que la limite de détection (40 ppm par pixel).

Il faut donc soit améliorer le vide, soit plutôt travailler avec une sonde plus intense et / ou balayant un champ moins grand.

On note maintenant C le contraste minimum observable, Np le courant dans la sonde, en ions / seconde, N le nombre de pixels par image, t le temps de pose de l'image électronique, ρ la densité atomique de l'échantillon, S le rendement de pulvérisation ionique de l'échantillon et e l'épaisseur érodée.

Il a été observé que

$C = K\sqrt{N}/\sqrt{Np.t}$ où K est une constante

et $e = Np.S.t/\rho.N.d^2$

d'où $\rho.d^2.e = S.K^2/c^2$

Ceci montre que le contraste observable est limité essentiellement:

- par l'épaisseur e que l'on peut éroser sans nuire à la résolution (donnée par le diamètre d), et
- par le rendement de pulvérisation S.

On peut aussi relier ces enseignements à ceux donnés plus haut, car:

$\varepsilon = e/t = Np.S/\rho.N.d^2$

$$\text{d'où } \frac{Nv}{NA} = 50 \cdot \frac{\rho\, Nd^2}{Np.S} \cdot p$$

Si l'on prend maintenant $N = 10^4$ et $p = 5.10^{-9}$, le tableau suivant donne les résultats.

| Diamètre sonde d (microns) | Courant sonde Np (ions / seconde) | Nv / NA ($6,6.10^{-7}$ Pascal ou $5.10^{-9}$ Torr; $10^4$ pixels) |
|---|---|---|
| 0,02 | $4.10^5$ | 0,5 |
| 0,05 | $4.10^6$ | 0,05 |
| 0,1 | $4.10^7$ | 0,005 |
| 0,5 | $3.10^9$ | $6.10^{-5}$ |

Ces évaluations supposent que la vitesse de balayage du faisceau est suffisamment élevée pour que tout se passe comme si l'érosion se déroulait sous l'effet d'un bombardement uniforme, malgré le balayage de trame de type télévision.

Différents moyens permettent de réduire ces effets, en particulier l'utilisation d'un balayage à commande numérique, beaucoup plus souple, ou encore l'élimination du début de l'émission (par conséquent du régime transitoire de celle-ci).

**Revendictions**

1. Appareil pour la micro-analyse d'un échantillon solide, du type comportant, dans une enceinte (EN), mise sous vide (PC1, PC2):

- un porte-objet mobile (PO), propre à recevoir l'échantillon à analyser (EC);
- une source d'ions primaires (S10);
- des premiers moyens optiques électrostatiques (1) pour amener un faisceau d'ions primaires issus de la source à bombarder l'échantillon (EC); et
- de seconds moyens optiques électrostatiques (2) pour collecter des ions secondaires émis par l'échantillon, en réponse aux ions primaires qui le bombardent, et pour amener le faisceau d'ions secondaires ainsi collectés à l'entrée d'un analyseur d'ions, comprenant un spectromètre de masse (SP20);
- les premiers (1) et seconds (2) moyens optiques électrostatiques *comportant* une partie optique commune (5) *à éléments coaxiaux*, d'axe perpendiculaire au porte-objet (PO), et s'étendant jusqu'au voisinage de celui-ci, pour réaliser une collecte très efficace des ions secondaires, tout en traitant simultanément, par les mêmes organes optiques, les faisceaux d'ions primaires et secondaires,

*tandis qu'il est prévu un moyen de séparer les faisceaux d'ions primaires et secondaires (CS54);*

- *caractérisé* en ce que les premiers (1) et seconds (2) moyens optiques comportent, à l'extrémité de ladite partie optique commune (5) qui est opposée à l'échantillon, des moyens propres à imprimer un balayage du faisceau primaire d'ions (B13) dont le centre de pivotement se trouve sur l'axe de la partie optique commune (5), associés à des moyens propres à assurer une correction dynamique synchrone *des effets du balayage primaire* sur le faisceau d'ions secondaires (B23) dont le centre de pivotement se trouve au niveau d'une image du "cross-over" ($CO_3$), donnée par l'optique de collecte des ions secondaires; et

- en ce qu'il est prévu un moyen autonome d'observation *de l'échantillon au moyen d'électrons revenant de celui-ci, ledit moyen*, comprenant des organes optiques magnétiques (M31, M552, M571) incorporés coaxialement à la partie optique commune (5), réglables de façon sensiblement découplée des premiers et seconds moyens optiques électrostatiques, ainsi que des moyens (CS54) pour appliquer un champ magnétique transverse à ladite extrémité de la partie optique commune *qui est opposée à l'échantillon,* afin de séparer les faisceaux d'électrons et d'ions, ce qui permet l'obtention simultanée d'une image ionique et d'une image électronique de l'échantillon par balayage.

2. Appareil selon la revendication 1, *caractérisé* en ce que le moyen autonome d'observation (3, 4) est agencé en microscope électronique, à balayage, dont les moyens de balayage (B56) sont incorporés à ladite partie optique commune.

3. Appareil selon l'une des revendications 1 et 2, *caractérisé* en ce que la partie optique commune comporte, au voisinage immédiat du porte-objet, une optique rapprochée (OR57), propre à coopérer avec l'échantillon pour:

- d'une part réaliser une focalisation d'une image (I5) de la source d'ions, dont l'ouverture angulaire est délimitée par un diaphragme (D570) au niveau duquel est formée une image du centre de pivotement du balayage du faisceau primaire, la focalisation incluant une correction dynamique synchrone tenant compte du balayage;
- d'autre part réaliser une collecte large et efficace tant des électrons que des ions secondaires en formant des images ionique et électronique au voisinage du même diaphragme.

4. Appareil selon la revendication 3, *caractérisé* en ce que l'optique rapprochée (OR57) comprend, du diaphragme à l'échantillon:

- une électrode annulaire, mise à la masse (L572);
- une électrode de contrôle de la collecte (L573), alimentée avec la même polarité que l'échantillon (EC);
- une électrode de focalisation (L574), alimentée avec la polarité opposée; et
- une électrode (L575), placée au voisinage de l'échantillon pour en délimiter la surface susceptible de perturber les champs électriques de focalisation et alimentée avec la même polarité que l'échantillon, laquelle est opposée à celle des ions primaires incidents.

5. Appareil selon l'une des revendications 3 et 4, *caractérisé* en ce que l'énergie du faisceau d'ions primaires est augmentée environ de moitié dans l'optique rapprochée (OR57).

6. Appareil selon la revendication 5, *caractérisé* en ce que l'énergie du faisceau d'ions primaires est de l'ordre de 10 keV en amont de l'optique rapprochée (OR57), pour être portée à environ 15 keV par la coopération de cette optique rapprochée (OR57) avec l'échantillon, tandis que l'énergie des ions secondaires est sensiblement égale à l'augmentation d'énergie que subissent les ions primaires du fait de l'optique rapprochée (OR57).

7. Appareil selon l'une des revendications 3 à 6, *caractérisé* en ce qu'il comporte une lentille magnétique (M571) au voisinage du diaphragme (D570) de l'optique rapprochée (OR57).

8. Appareil selon l'une des revendications 3 à 7, *caractérisé* en ce que l'optique rapprochée (OR57) fait partie d'une optique de formation de la sonde ionique et de collecte (FC57), qui comporte encore une lentille électrostatique (L576) en amont du diaphragme (D570).

9. Appareil selon la revendication 3, *caractérisé* en ce que la partie commune coaxiale (5) comporte en amont de ladite optique (FC57):

- un combinateur-séparateur de faisceaux (CS54) comprenant une paire de plaques électrostatiques, et définissant le centre de pivotement;
- une optique de mise en forme des faisceaux ioniques et électroniques (MF55); et
- des moyens de balayage des faisceaux électroniques (B56).

10. Appareil selon la revendication 9, *caractérisé* en ce que:

- l'optique de mise en forme (MF55) comprend une lentille magnétique (M552) suivie de deux lentilles électrostatiques (L554, L555) polarisées par des tensions opposées, et
- les moyens de balayage des faisceaux électroniques comprennent deux ensembles de deux bobines électromagnétiques disposées l'une derrière l'autre (B56 a et b).

11. Appareil selon l'une des revendications précédentes, *caractérisé* en ce que les moyens de balayage ionique comprennent deux paires de plaques (B131, B132) placées à la suite de deux secteurs électrostatiques (S121, S122) du côté des ions primaires, et deux paires de plaques (B234, B235) précédant deux secteurs électrostatiques (S223, S224) du côté des ions secondaires, l'ensemble étant agencé pour rendre le faisceau secondaire stationnaire à la sortie de (S224) quel que soit le balayage imprimé au faisceau primaire.

12. Appareil selon la revendication 11, *caractérisé* en ce qu'il est prévu d'une part une lentille électrostatique de couplage (A123) entre les deux secteurs électrostatiques primaires, d'autre part une fente de filtrage d'énergie (Fe22) suivie d'une lentille électrostatique de couplage (L227) entre les deux secteurs électrostatiques secondaires (S223, S224).

13. Appareil selon l'une des revendications précédentes, *caractérisé* en ce que les premiers moyens optiques (1) comportent, après la source d'ions, une optique de réglage du diamètre de la sonde ionique (R11).

14. Appareil selon l'une des revendications précédentes, *caractérisé* en ce que les premiers moyens optiques (1) forment des images successivement réduites (Il - I5, figure 4A) de la source d'ions, tandis que les images ionique et électronique formées au voisinage du diaphragme (D570) possèdent un grandissement sensiblement égal à l'unité.

15. Appareil selon l'une des revendications précédentes, *caractérisé* en ce que l'analyseur d'ions comprend une optique de transfert (021) suivie d'un spectromètre de masse à grande clarté, capable de détection multiple simultanée (SP20).

16. Appareil selon l'une des revendications précédentes, *caractérisé* en ce qu'il comprend, coaxialement à ladite partie optique commune, et en amont de celle-ci, un canon à électrons (S30) suivie d'une lentille magnétique (M31) de réglage du diamètre de la sonde électronique.

17. Appareil selon la revendication 16, *caractérisé* en ce que l'énergie des électrons primaires est de l'ordre de 30 keV.

18. Appareil selon la revendication 16, *caractérisé* en ce que l'énergie des électrons primaires est de l'ordre de 100 keV, l'échantillon étant mince, et observé par transmission.

19. Appareil selon l'une des revendications 1 à 18, *caractérisé* en ce qu'il comprend, à partir de l'extrémité de la partie commune (5) qui est opposée à l'échantillon, un autre secteur électrostatique (S405) qui reprend les électrons secondaires pour les amener dans un détecteur.

**Patentansprüche**

1. Gerät für die Mikroanalyse einer festen Probe des Typs, der in einem Gehäuse (EN) unter Vakuum (PC1, PC2) folgende Bestandteile aufweist:

- einenbeweglichen Objektträger (PO), der geeignet ist, die zu analysierende Probe (EC) aufzunehmen;
- eine Primärionenquelle (S10);
- erste optische, elektrostatische Mittel (1) für die Zuleitung eines Strahles von Primärionen, die von der Quelle ausgesandt worden sind, um die Probe (EC) zu bombardieren; und

- zweite optische, elektrostatische Mittel (2), um Sekundärionen zu sammeln, die von der Probe emittiert worden sind, aufgrund der auf sie eintreffenden Primärionen, und für die Zuführung des Strahles von auf diese Weise gesammelten Sekundärionen zum Eingang eines Ionen-Analysators, der ein Massenspektrometer (SP20) aufweist;
- die ersten (1) und zweiten (2) optischen, elektrostatischen Mittel weisen einen gemeinsamen optischen Bereich (5) *mit coaxialen Elementen* auf, deren Achse senkrecht zum Objektträger (PO) verläuft und die sich bis in dessen Nachbarschaft erstrecken, damit eine sehr wirksame Sammlung der Sekundärionen gewährleistet ist, wobei die Primär- und Sekundärionenstrahlen gleichzeitig und durch die gleichen optischen Organe behandelt werden, und

*wobei ein Mittel zum trennen der Primär- und Sekundärionenstrahlen (CS54) vorgesehen ist;*

- *dadurch gekennzeichnet, daß* die ersten (1) und zweiten (2) optischen Mittel an dem der Probe entgegengesetzten Ende des genannten gemeinsamen optischen Teiles (5) Mittel aufweisen, die eine Abtastung des Primärionenstrahles gestatten (B13), deren Schwenkzentrum sich auf der Achse des gemeinsamen optischen Teiles (5) befindet, und die mit Mitteln zusammenwirken, die eine dynamische synchrone Korrektur der Auswirkungen der Primär-Abtastung an dem Sekundärionenstrahl sicherstellen (B23), deren Schwenkzentrum sich auf dem Niveau eines "cross-over" -Bildes ($CO_3$) befindet, wobei dieses Bild durch die Sammeloptik der Sekundärionen gegeben ist; und

- dadurch, daß ein autonomes Mittel zur Beobachtung *der Probe mittels von ihr zurückkommender Elektronen vorgesehen* ist und dieses Mittel optische magnetische Organe (M31, M552, M571) aufweist, die coaxial zu dem gemeinsamen optischen Teil (5) angeordnet sind und die im wesentlichen abgekoppelt von den ersten und zweiten optischen elektrostatischen Mitteln geregelt werden können, sowie Mittel (CS54) um ein magnetisches Feld quer zu dem genannten, der Probe entgegengesetzten Ende des gemeinsamen optischen Teiles aufzubringen, um die Elektronen- und Ionen-Strahlen zu trennen, so daß man gleichzeitig ein Ionen-Bild und ein Elektronen-Bild der Probe durch Abtastung erhält.

2. Gerät nach Anspruch 1, *dadurch gekennzeichnet*, daß das autonome Beobachtungsmittel als Elektronenmikroskop zum Abtasten ausgebildet ist, dessen Abtastmittel (B56) in dem genannten gemeinsamen optischen Teil untergebracht sind.

3. Gerät nach einem der Ansprüch 1 und 2, *dadurch gekennzeichnet*, daß der gemeinsame optische Teil in unmittelbarer Nähe zum Objektträger eine Nah-Optik (OR57) aufweist, die mit der Probe zusammenwirkt, um:

- einerseits eine Fokussierung eines Bildes (I5) der Ionenquelle herbeizuführen, wobei die Winkelöffnung begrenzt wird durch ein Diaphragma (D570), auf dessen Niveau ein Bild des Schwenkzentrums des Abtastvorganges des Primärstrahles erzeugt wird, wobei die Fokussierung eine dynamische synchrone Korrektur beinhaltet, die den Abtastvorgang berücksichtigt;
- andererseits ein großes und effektives Sammeln sowohl von Elektronen wie auch von Sekundärionen sicherzustellen, indem Ionen- und Elektronen-Bilder in der Nähe des Diaphragmas erzeugt werden.

4. Gerät nach Anspruch 3, *dadurch gekennzeichnet*, daß die Nah-Optik (OR57) vom Diaphragma bis zur Probe folgendende Komponenten aufweist:

- eine Ringelektrode, die an Masse liegt (L572);
- eine gesteuerte Sammelelektrode (L573), die mit der gleichen Polarität versorgt wird, wie die Probe (EC);
- eine Fokussierungselektrode (L574), die mit entgegengesetzter Polarität versorgt wird; und
- eine Elektrode (L575), die in der Nähe der Probe angeordnet ist, zur Begrenzung deren Oberfläche, die geeignet ist, die elektrischen Fokussierungsfelder zu stören, und die mit der gleichen Polarität versorgt wird wie die Probe, wobei sie entgegengesetzt zu derjenigen für die auftreffenden Primärionen angeordnet ist.

5. Gerät nach einem der Ansprüche 3 und 4, *dadurch gekennzeichnet*, daß die Energie des Primärionenstrahls in der Nah-Optik (OR57) um etwa die Hälfte verstärkt wird.

6. Gerät nach Anspruch 5, *dadurch gekennzeichnet*, daß die Energie des Primärionenstrahls in der Größenordnung von 10 keV stromaufwärts der Nah-Optik (OR57) liegt und durch das Zusammenwirken dieser Nah-Optik (OR57) mit der Probe auf etwa 15 keV gebracht wird, während die Energie der Sekundärionen im wesentlichen gleich ist mit der Energieerhöhung, die von den Primärionen aufgrund der Nah-Optik (OR57) durchgemacht wird.

7. Gerät nach einem der Ansprüche 3 bis 6, *dadurch gekennzeichnet*, daß es eine magnetische Linse (M571) in der Nähe des Diaphragmas (D570) der Nah-Optik (OR57) aufweist.

8. Gerät nach einem der Ansprüche 3 bis 7, *dadurch gekennzeichnet*, daß die Nah-Optik Teil einer Optik für die Bildung der Ionen-Sonde und für das Sammeln (FC57) ist, die noch eine elektrostatische Linse (L576) stromaufwärts des Diaphragmas (D570) aufweist.

9. Gerät nach Anspruch 3, *dadurch gekennzeichnet*, daß der gemeinsame coaxiale Teil (5) stromaufwärts der genannten Optik (FC57) folgende Bestandteile aufweist:

- einen Strahl-Trennschalter (CS54) mit einem Paar elektrostatischer Platten zum definieren des Schwenkzentrums;
- eine Optik zum in Form bringen der Ionen- und Elektronenstrahlen (MF55); und
- Mittel zum abtasten der Elektronenstrahlen (B56).

10. Gerät nach Anspruch 9, *dadurch gekennzeichnet*, daß:

- die Optik zum in Form bringen (MF55) eine magnetische Linse (M552) aufweist, hinter der zwei elektrostatische Linsen (L554, L555) angeordnet sind, die durch entgegengesetzte Spannungen polarisiert sind; und
- die Mittel zum Abtasten *der Elektronenstrahlen* zwei Einheiten aus zwei elektromagnetischen Spulen aufweisen, die hintereinander angeordnet sind (B56a und b).

11. Gerät nach einem der vorhergehenden Ansprüche, *dadurch gekennzeichnet*, daß die Mittel zur Ionen-Abtastung zwei Paare von Latten (B131, B132) aufweisen, die nach zwei elektrostatischen Sektoren (S121, S122) seitlich der Primärionen angeordnet sind, und zwei Paare von Platten (B234, B235), die vor zwei elektrostatischen Sektoren (S223, S224) seitlich der Sekundärionen angeordnet sind, wobei das Ganze so eingerichtet ist, daß der Sekundärstrahl am Ausgang von (S224) stationär bleibt, wie auch immer die Abtastung auf den Primärstrahl einwirkt.

12. Gerät nach Anspruch 11, *dadurch gekennzeichnet*, daß einerseits eine elektrostatische Kopplungslinse (A123) zwischen den beiden primären elektrostatischen Sektoren vorgesehen und das andererseits eine Spaltblende zum Filtern der Energie (Fe22) gefolgt von einer elektrostatischen Kopplungslinse (L227) zwischen den beiden sekundären elektrostatischen Sektoren (S223, S224) angeordnet ist.

13. Gerät nach einem der vorhergehenden Ansprüche, *dadurch gekennzeichnet*, daß die ersten optischen Mittel (1) hinter der Ionenquelle eine Optik zur Regelung des Durchmessers der Ionen-Sonde aufweisen (R11).

14. Gerät nach einem der vorhergehenden Ansprüche, *dadurch gekennzeichnet*, daß die ersten optischen Mittel (1) aufeinanderfolgend verkleinerte Bilder (I1 - I5, Figur 4A) Ionenquelle erzeugen, während die in der Nähe des Diaphragmas (D570) erzeugten Ionen- und Elektronen-Bilder eine Vergrößerung aufweisen, die nahezu gleich der Einheit ist.

15. Gerät nach einem der vorhergehenden Ansprüche, *dadurch gekennzeichnet*, daß der Ionen-Analysator eine Übertragungsoptik (021) aufweist, die von einem Massenspektrometer großer Helligkeit gefolgt ist, zur gleichzeitigen Mehrfach-Anzeige (SP20).

16. Gerät nach einem der vorhergehenden Ansprüche, *dadurch gekennzeichnet*, daß es coaxial zu dem genannten gemeinsamen optischen Teil und stromaufwärts hierzu eine Elektronen (S30) aufweist, die von einer magnetischen Linse (M31) zur Regelung des Durchmesser der elektronischen Sonde gefolgt ist.

17. Gerät nach Anspruch 16, *dadurch gekennzeichnet*, daß die Energie der Primärelektronen in der Größenordnung von 30 keV liegt.

18. Gerät nach Anspruch 16, *dadurch gekennzeichnet*, daß die Energie der Primärelektronen in der Größenordnung von 100 keV liegt, wobei die Probe dünn ist und durch Transmission betrachtet wird.

19. Gerät nach einem der Ansprüche 1 bis 18, *dadurch gekennzeichnet*, daß es ausgehend von dem der Probe entgegengesetzten Ende des gemeinsamen Teiles (5) einen anderen elektrostatischen Sektor (S405) aufweist, der Sekundärelektronen aufnimmt, um sie einem Detektor zuzuführen.

**Claims**

1. An apparatus for the micro-analysis of a solid specimen of the type comprising in a casing (EN) provided with a vacuum (PC1, PC2):

- a movable stage (PO) capable of receiving the specimen to be analysed (EC);
- a source (S10) of primary ions;
- first electrostatic optical means (1) to cause a beam of primary ions coming from the source to bombard the specimen (EC); and
- second electrostatic optical means (2) to collect the secondary ions emitted by the specimen, in response to the primary ions bombarding it, and to pass the beam of secondary ions thus collected to the input of an ions analyser, comprising a mass spectrometer (SP 20);
- the first electrostatic optical means (1) and the second electrostatic optical means (2) *comprising* a common optical section (5) with *coaxial elements* with their axes perpendicular to the stage (PO) and extending as far as the vicinity of the latter in order to obtain a very effective collection of the secondary ions, whilst simultaneously treating the primary and secondary ion beams by means of the same optical components *while provision is made for a means (CS54) for separating the primary and secondary ion beams; characterized* in that the first optical means (1) and second optical means (2) comprise at the end of the said common optical section (5) on the opposite side to the specimen, means capable of providing scanning of the primary ion beam (B13) whose centre of pivoting is located on the axis of the common optical section (5), associated with means capable of ensuring a synchronous dynamic correction of *the effects of the primary scanning* on the secondary ion beam (B23) whose centre of pivoting is located at the level of an image of the cross-over (CO3) given by the optics of the collection of the secondary ions; and

– in that provision is made for an independent means for observing *the specimen by means of electrons returning from the latter*, the said means comprising magnetic optical components (M31, M552, M571) coaxially incorporated in the common optical section (5), which are adjustable in a manner substantially detached from the first and second electrostatic optical means, as well as for means (CS54) for applying a transverse magnetic field to the said end of the common optical section *which is on the opposite side to the specimen*, in order to separate the electron and ion beams, which makes it possible to obtain simultaneously an ionic image and an electronic image of the specimen by scanning.

2. An apparatus according to claim 1 *characterized* in that the independent observation means is arranged as a scanning electron microscope whose scanning means (B56) are incorporated in the said common optical section.

3. An apparatus according to one of claims 1 and 2, *characterized* in that the common optical section comprises in the immediate vicinity of the stage, a near optical unit (OR57) capable of cooperating with the specimen for:

– obtaining, on the one hand, the focusing of an image (I5) of the ion source, whose angular aperture is delimited by a diaphragm (D570) at the level whereof there is formed an image of the centre of pivoting of the primary beam scan, the focusing including a synchronous dynamic correction taking the scanning into account;
– obtaining, on the other hand, a wide and effective collection of both the electrons and secondary ions, while forming ionic and electronic images near the same diaphragm.

4. An apparatus according to claim 3, *characterized* in that the near optical unit (OR57) comprises, from the diaphragm to the specimen:

– an earthed annular electrode (L572);
– an electrode for controlling the collection (L573), supplied with the same polarity as the specimen (EC);
– a focusing electrode (L574) supplied with the opposite polarity; and
– an electrode (L575) placed near the specimen to delimit the surface liable to disturb the electric focusing fields and supplied with the same polarity as the specimen, which is the opposite of that of the primary incident ions.

5. An apparatus according to one of claims 3 and 4, *characterized* in that the energy of the beam of primary ions is increased by approximately one half in the near optical unit (OR57).

6. An apparatus according to claim 5, *characterized* in that the energy of the beam of primary ions is of the order of 10 keV ahead of the near optical unit (OR57), to be brought to approximately 15 keV by the cooperation of this near optical unit (OR57) with the specimen, while the energy of the secondary ions is substantially equal to the increase in energy experienced by the primary ions because of the near optical unit (OR57).

7. An apparatus according to one of claims 3 to 6, *characterized* in that it comprises a magnetic lens (M571) near the diaphragm (D570) of the near optical unit (OR57).

8. An apparatus according to one of claims 3 to 7, *characterized* in that the near optical unit (OR57) forms part of an optical system for forming the ionic and collection probe (FC57) which comprises in addition, an electrostatic lens (L576) ahead of the diaphragm (D570).

9. An apparatus according to claim 3, *characterized* in that the coaxial common optical section (5) comprises ahead of the said optical unit (FC57):

– a combining-separating unit (CS54) for the beams, comprising a pair of electrostatic plates, and defining the pivoting centre;
– a unit (MF55) for shaping the ionic and electron beams; and
means (B56) for scanning the electron beams.

10. An apparatus according to claim 9, *characterized* in that:

– the optical shaping unit comprises a magnetic lens (M552) followed by two electrostatic lenses (L554, L555) polarized with opposite voltages and

- the means for scanning the *electron beams* comprise two sets of two electromagnetic coils disposed one behind the other (B56 a and b).

11. An apparatus according to one of the preceding claims, *characterized* in that the ionic scanning means comprise two pairs of plates (B131, B132) placed down-line from two electrostatic sectors (S121, S122) on the side of the primary ions and two pairs of plates (B234, B235) preceding two electrostatic sectors (S223, S224) on the side of the secondary ions, the set being arranged to render the secondary beam stationary at the output of (S224) irrespective of the scanning imparted to the primary beam.

12. An apparatus according to claim 11, *characterized* in that provision is made on the one hand for an electrostatic coupling lens (A123) between the two primary electrostatic sectors, on the other hand, for an energy filtering gap (Fe22) followed by a coupling electrostatic lens (L227) between the two secondary electrostatic sectors (S223, S224).

13. An apparatus according to one of the preceding claims, *characterized* in that the first optical means (1) comprise, after the source of ions, an optical unit for adjusting the diameter of the ionic probe (R11).

14. An apparatus according to one of the preceding claims, *characterized* in that the first optical means (1) form successively reduced images (I1 - I5 Figure 4A) of the source of the ions, while the ionic and electronic images formed near the diaphragm (D570) have a magnification which is substantially equal to unity.

15. An apparatus according to one of the preceding claims, *characterized* in that the ion analyser comprises a transfer optical unit (O21) followed by a mass spectrometer (SP20) of great clarity capable of simultaneous multiple detection.

16. An apparatus according to one of the preceding claims, *characterized* in that it comprises coaxially with the said common optical section, and ahead of the latter, an electron gun (S30) followed by a magnetic lens (M31) for adjusting the diameter of the electronic probe.

17. An apparatus according to claim 16, *characterized* in that the energy of the primary electrons is of the order of 30 keV.

18. An apparatus according to claim 16, *characterized* in that the energy of the primary electrons is of the order of 100 keV, the specimen being thin and being observed by way of transmission.

19. An apparatus according to one of claims 1 to 18, *characterized* in that it comprises, starting from the end of the common unit (5) *on the opposite side to the specimen,* another electrostatic sector (S405) which takes up the secondary electrons to pass them into a detector.

FIG.1

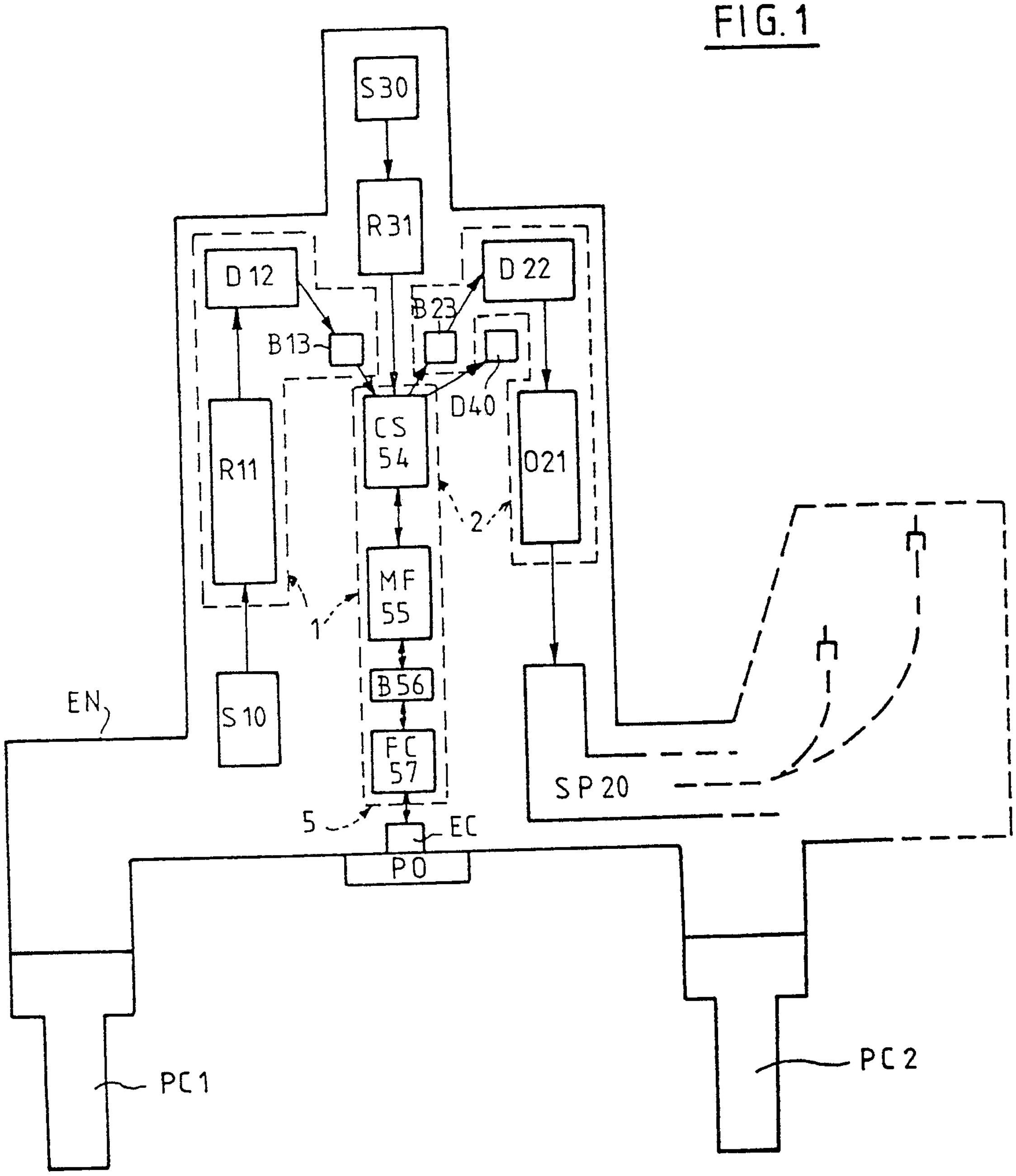
S30
R31
D 12
D 22
B 13
B 23
D40
CS 54
R11
O21
MF 55
B56
FC 57
S10
SP 20
EN
5
1
2
EC
PO
PC1
PC2

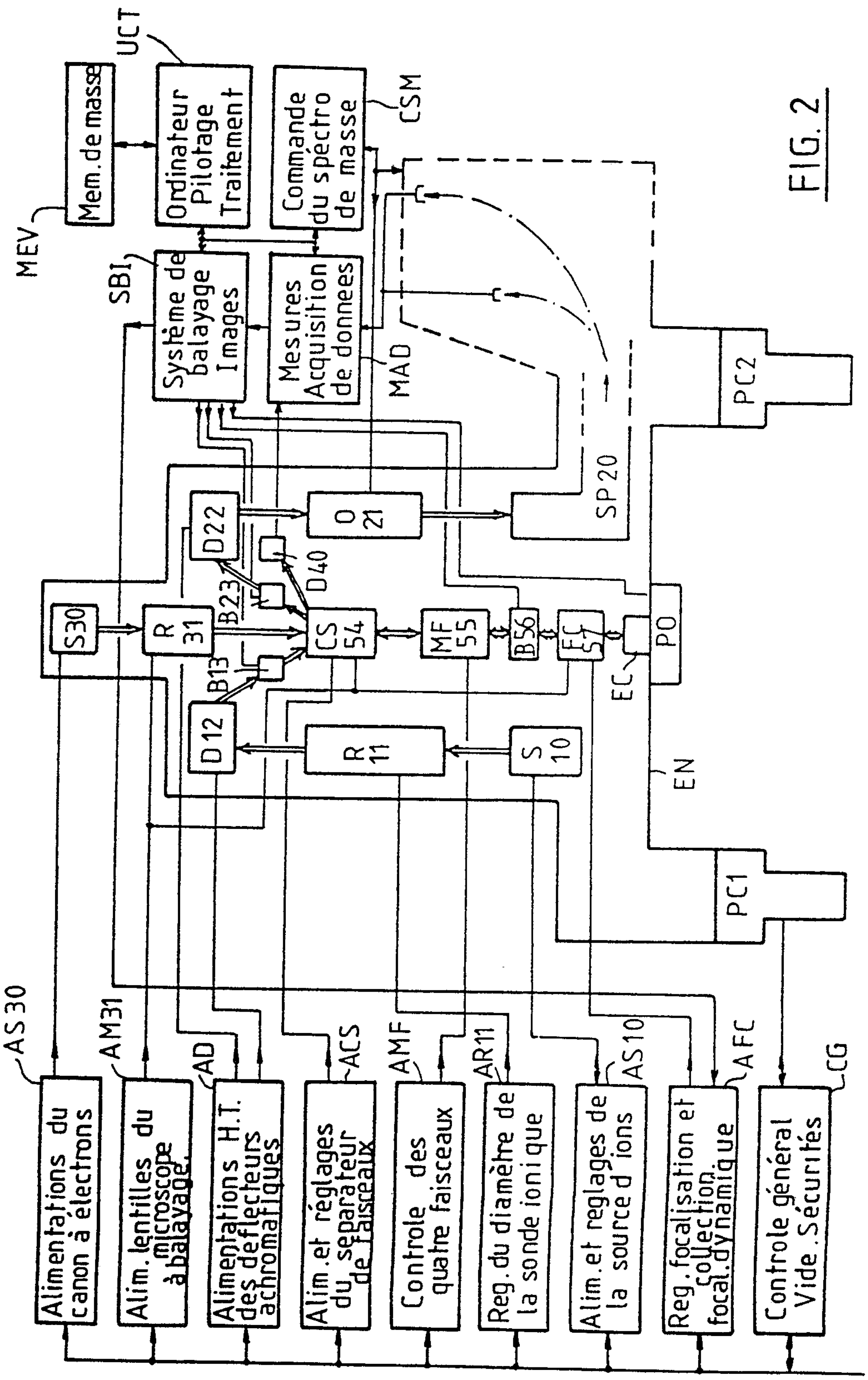
MEV
Mem. de masse
UCT
Ordinateur Pilotage Traitement
Commande du spectro de masse
CSM
SB1
Système de balayage Images
Mesures Acquisition de donnees
MAD
SP20
D22
O 21
D40
B23
S30
R 31
CS 54
MF 55
B56
FC 57
PO
EC
B13
D12
R 11
S 10
EN
PC2
PC1
AS 30
AM31
AD
ACS
AMF
AR11
AS10
AFC
CG
Alimentations du canon à électrons
Alim. lentilles du microscope à balayage.
Alimentations H.T. des deflecteurs achromatiques
Alim. et réglages du separateur de faisceaux
Controle des quatre faisceaux
Reg. du diamètre de la sonde ionique
Alim. et reglages de la source d'ions
Reg. focalisation et collection. focal. dynamique
Controle général Vide. Sécurités

FIG. 2

FIG.3

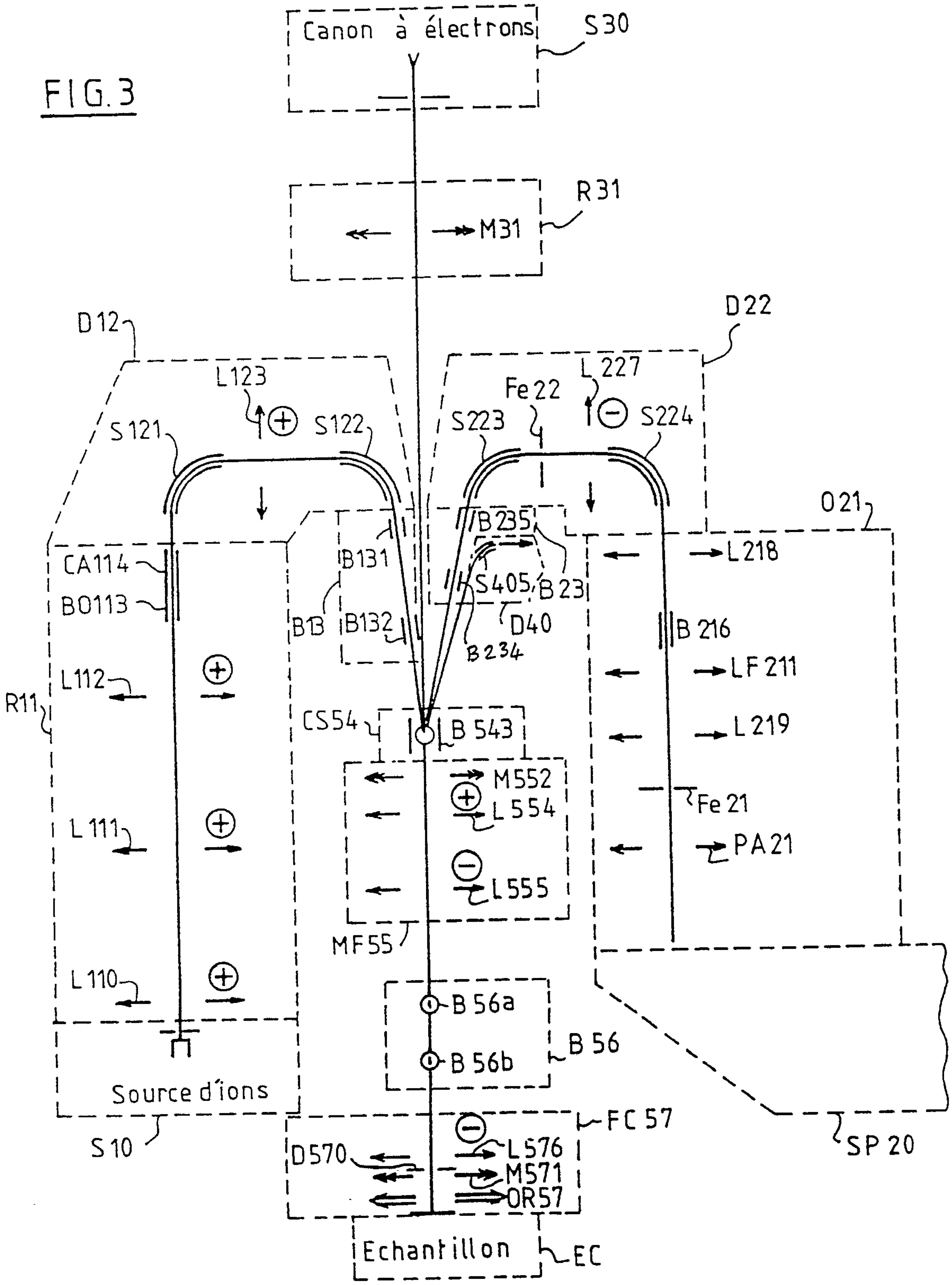
Canon à électrons
S30
R31
M31
D12
D22
L123
L227
Fe22
S121
S122
S223
S224
021
B235
L218
CA114
B131
S405
B23
BO113
B13
B132
D40
B216
B234
L112
LF211
R11
CS54
B543
L219
M552
L554
Fe21
L111
PA21
L555
MF55
L110
B56a
B56b
B56
Source d'ions
FC57
S10
SP20
L576
D570
M571
OR57
Echantillon
EC

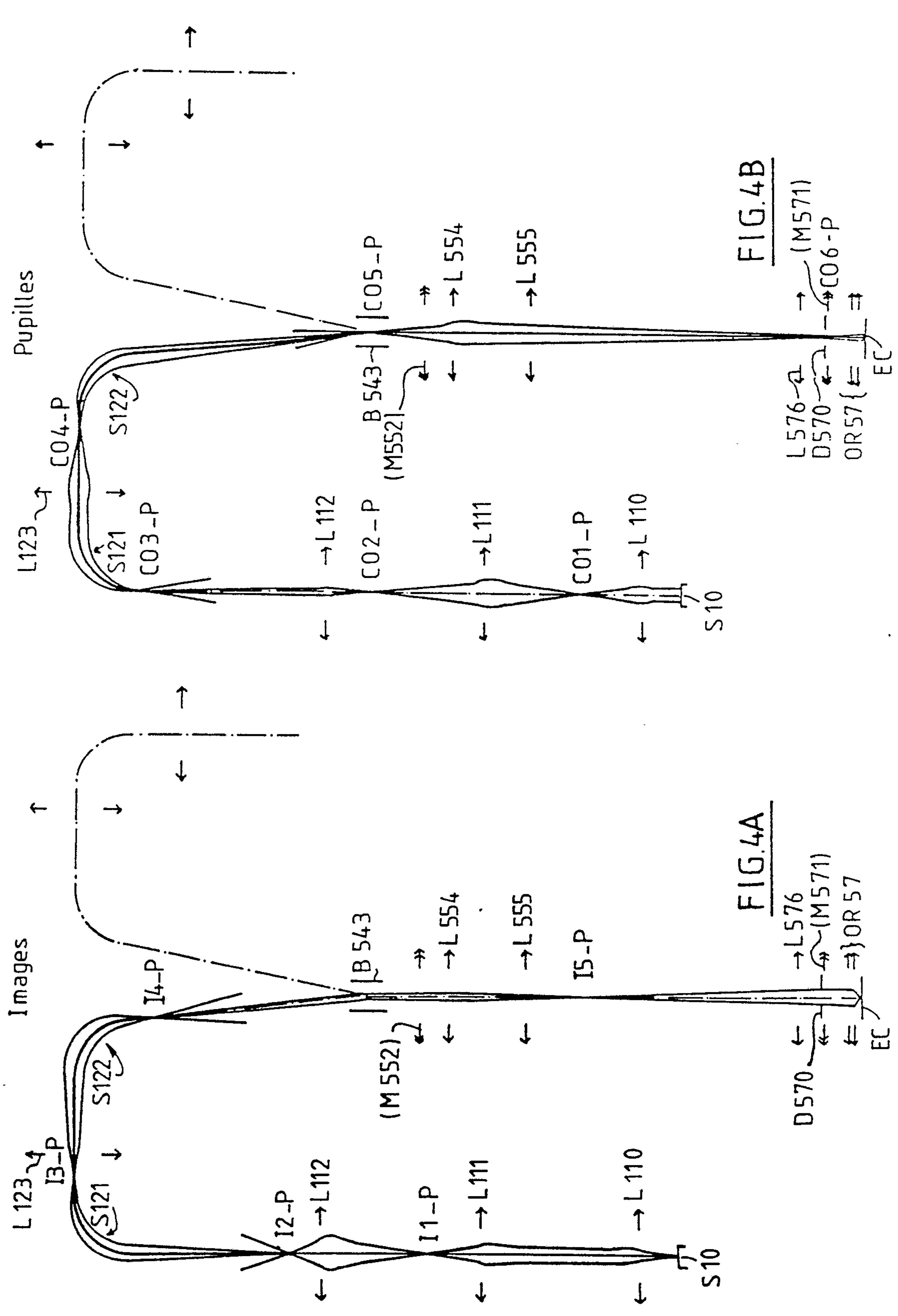
Pupilles
FIG.4B
S10
L 110
C01-P
L111
C02-P
L 112
C03-P
S121
L123
C04-P
S122
B 543
(M552)
C05-P
L 554
L 555
L576
D570
OR57
EC
C06-P
(M571)
Images
FIG.4A
S10
L 110
I1-P
L111
I2-P
L112
S121
L 123
I3-P
S122
I4-P
B 543
(M 552)
L 554
L 555
I5-P
L 576
(M571)
OR 57
D570
EC

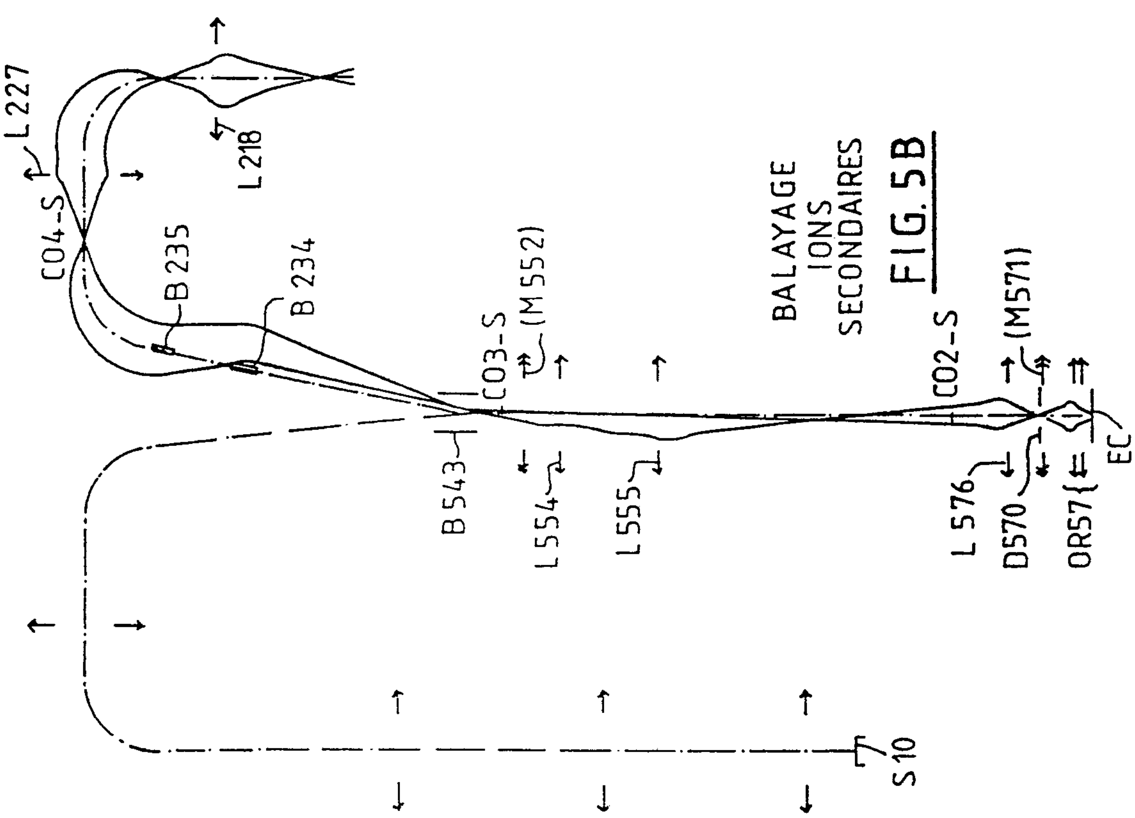


BALAYAGE IONS SECONDAIRES

FIG. 5B

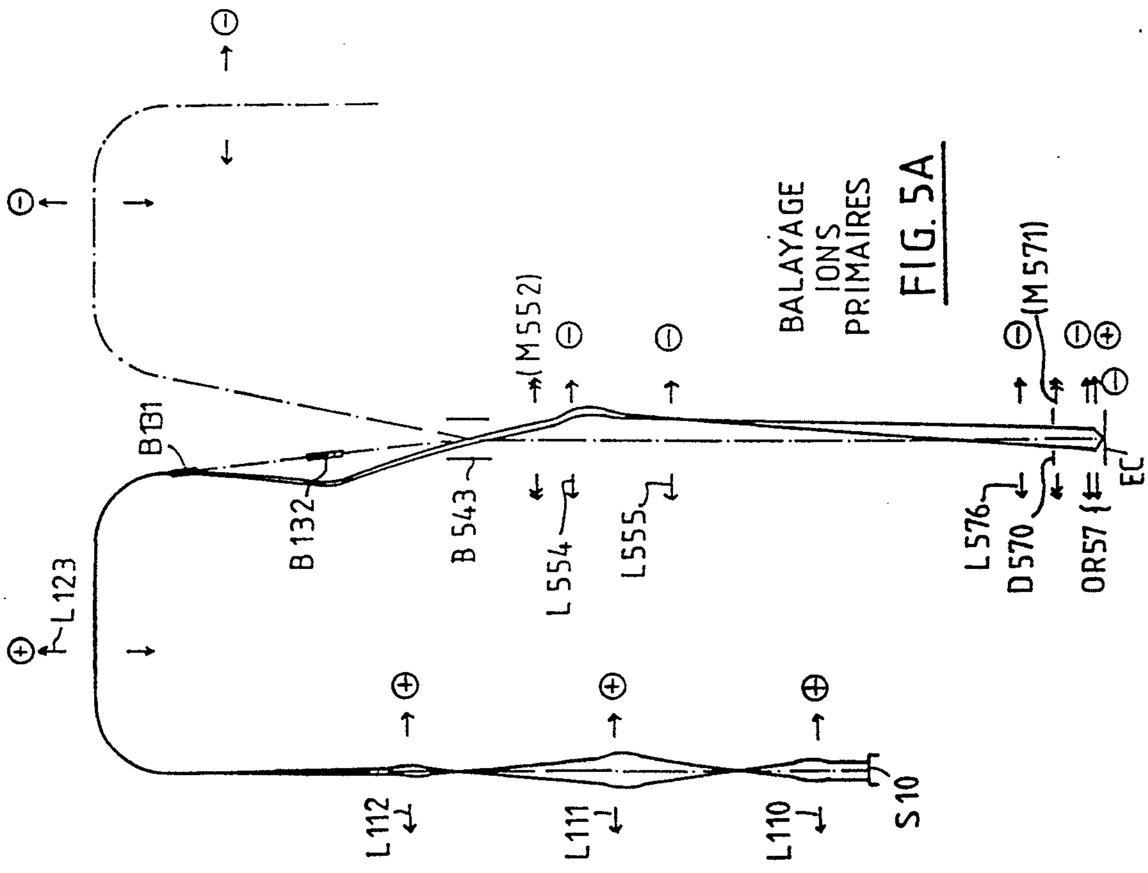


BALAYAGE IONS PRIMAIRES

FIG. 5A

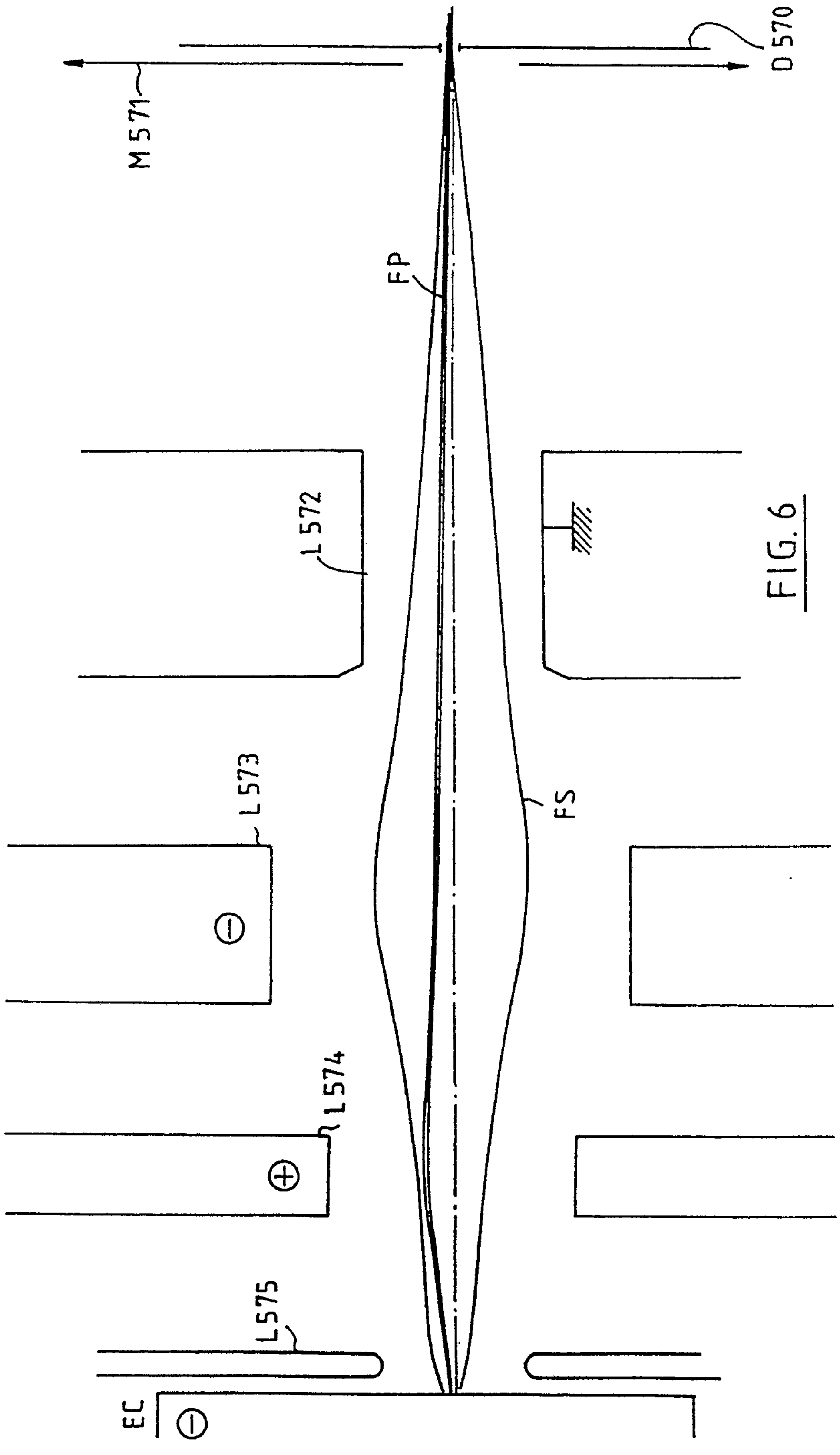


FIG. 6

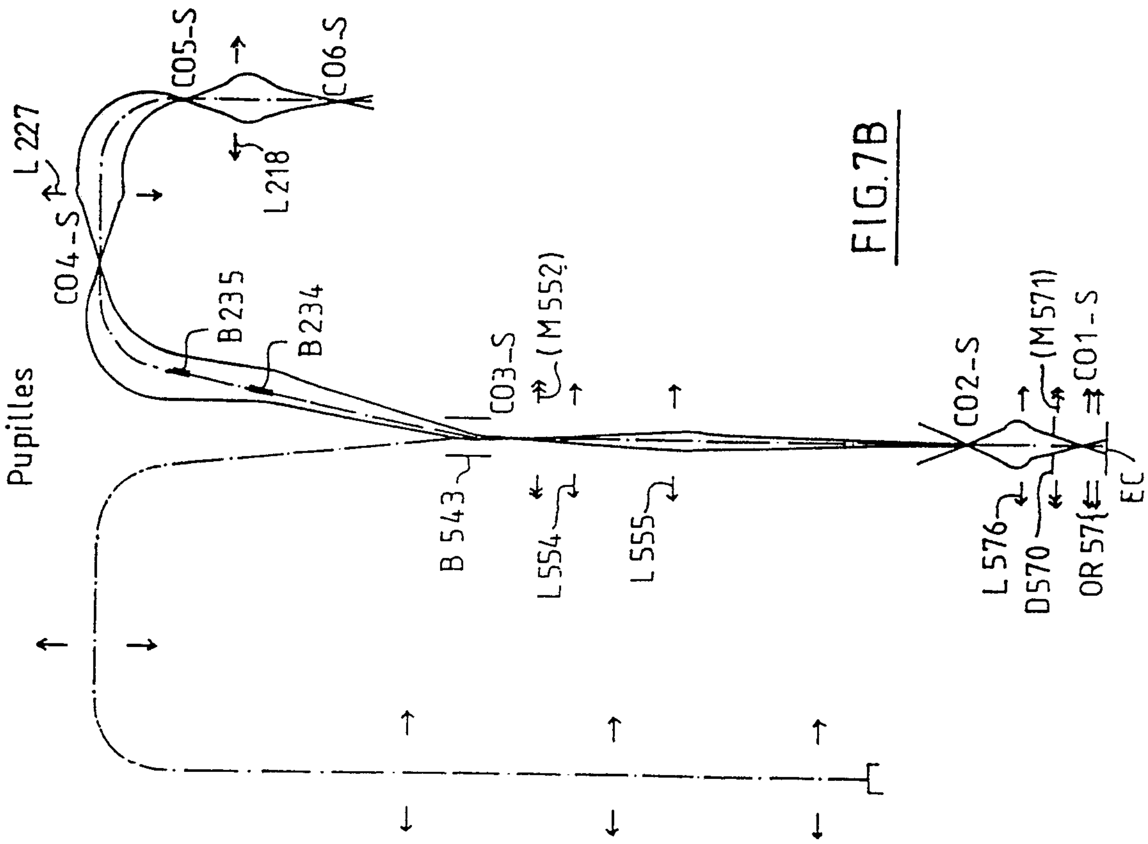
Pupilles
CO5-S
CO6-S
L 227
L 218
CO4-S
B 235
B 234
CO3-S
(M 552)
B 543
L 554
L 555
CO2-S
(M 571)
CO1-S
L 576
D 570
OR 57
EC

FIG.7B

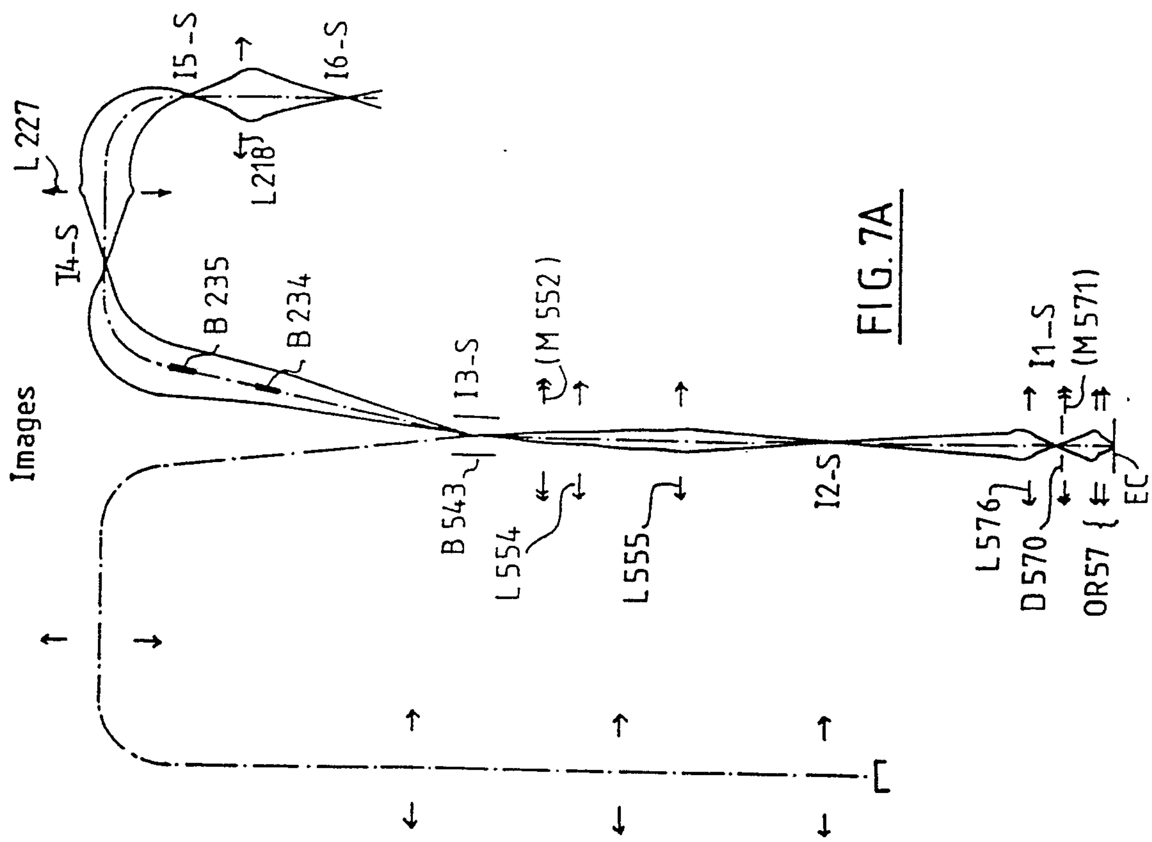
Images
I5-S
I6-S
L 227
L 218
I4-S
B 235
B 234
I3-S
(M 552)
B 543
L 554
L 555
I2-S
I1-S
(M 571)
L 576
D 570
OR57
EC

FIG. 7A

FIG. 8

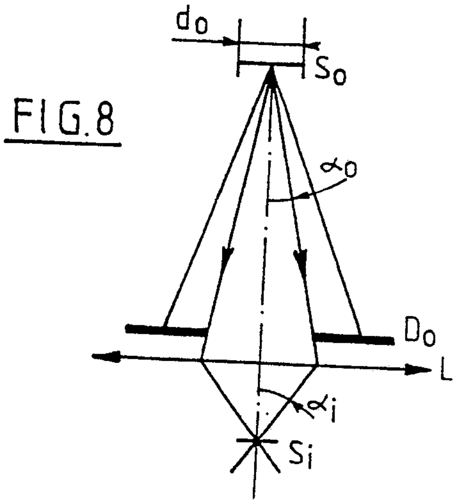


FIG. 8A

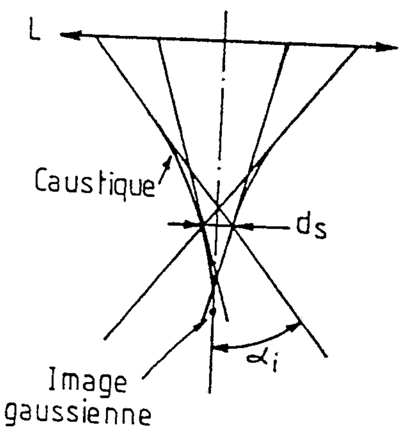


FIG. 8B

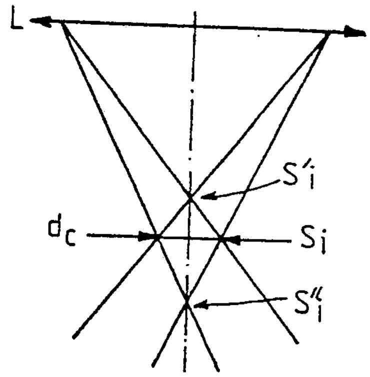


FIG. 8C

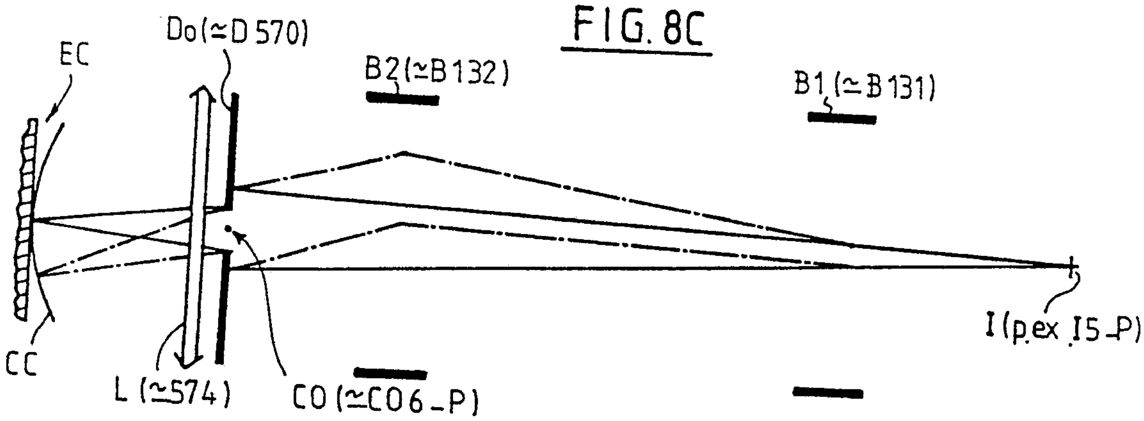

FIG. 9

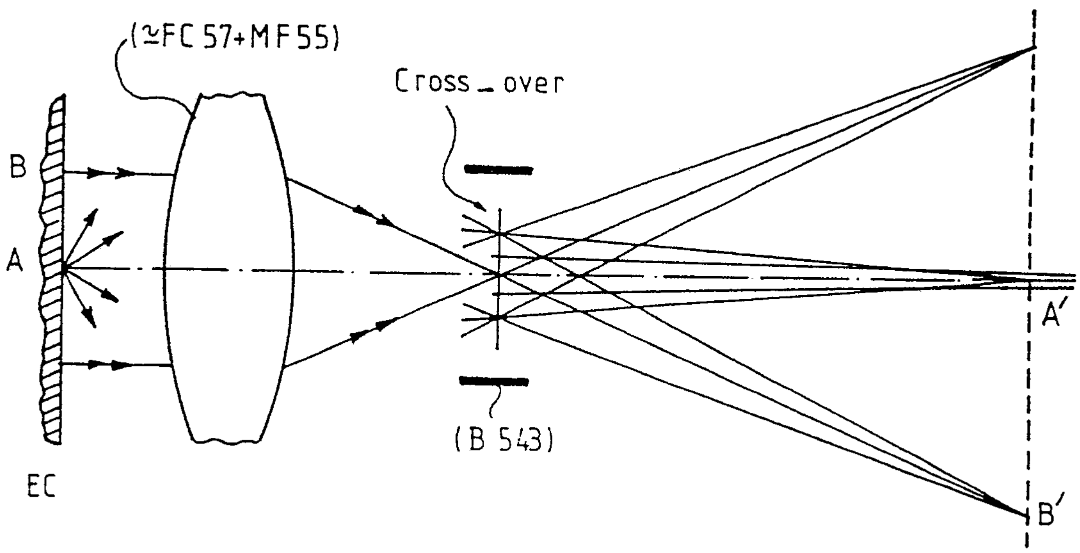


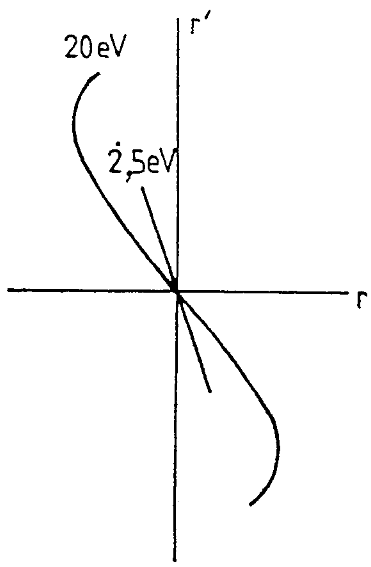


FIG. 9A

FIG. 10

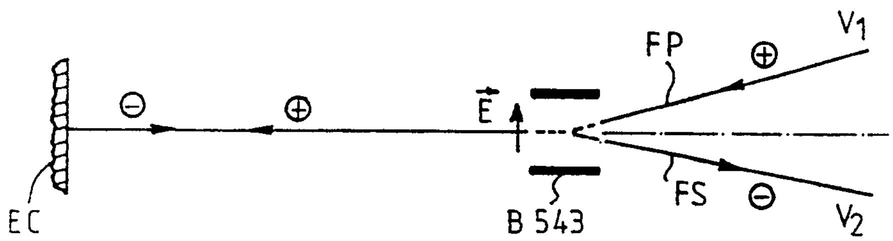
V1
FP
E
EC
B 543
FS
V2

FIG. 12

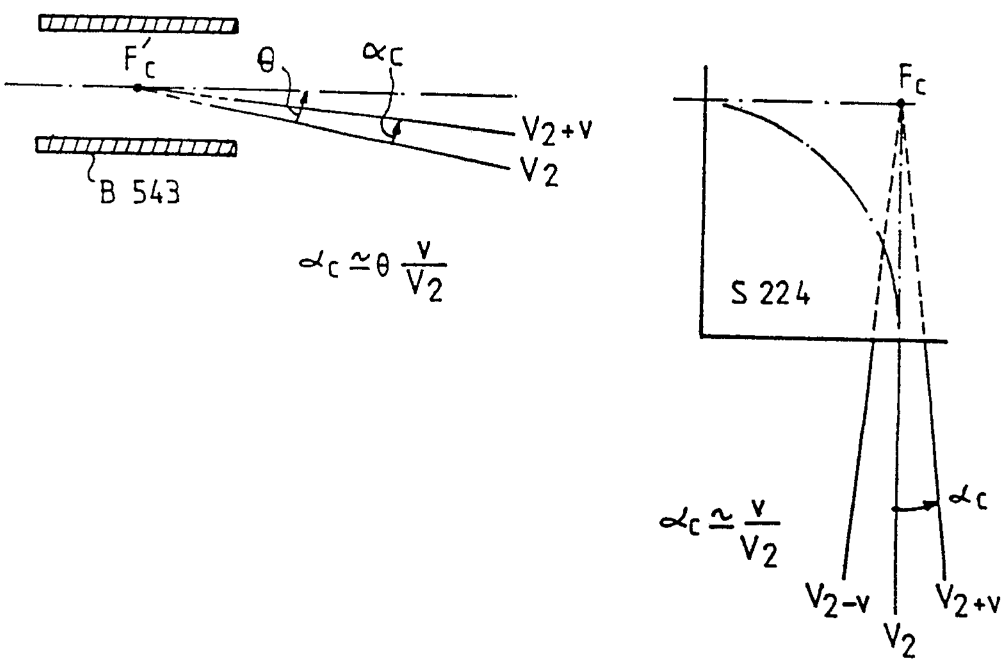
F'c
θ
αc
V2+v
V2
B 543
αc ≃ θ v/V2
Fc
S 224
αc ≃ v/V2
αc
V2-v
V2
V2+v

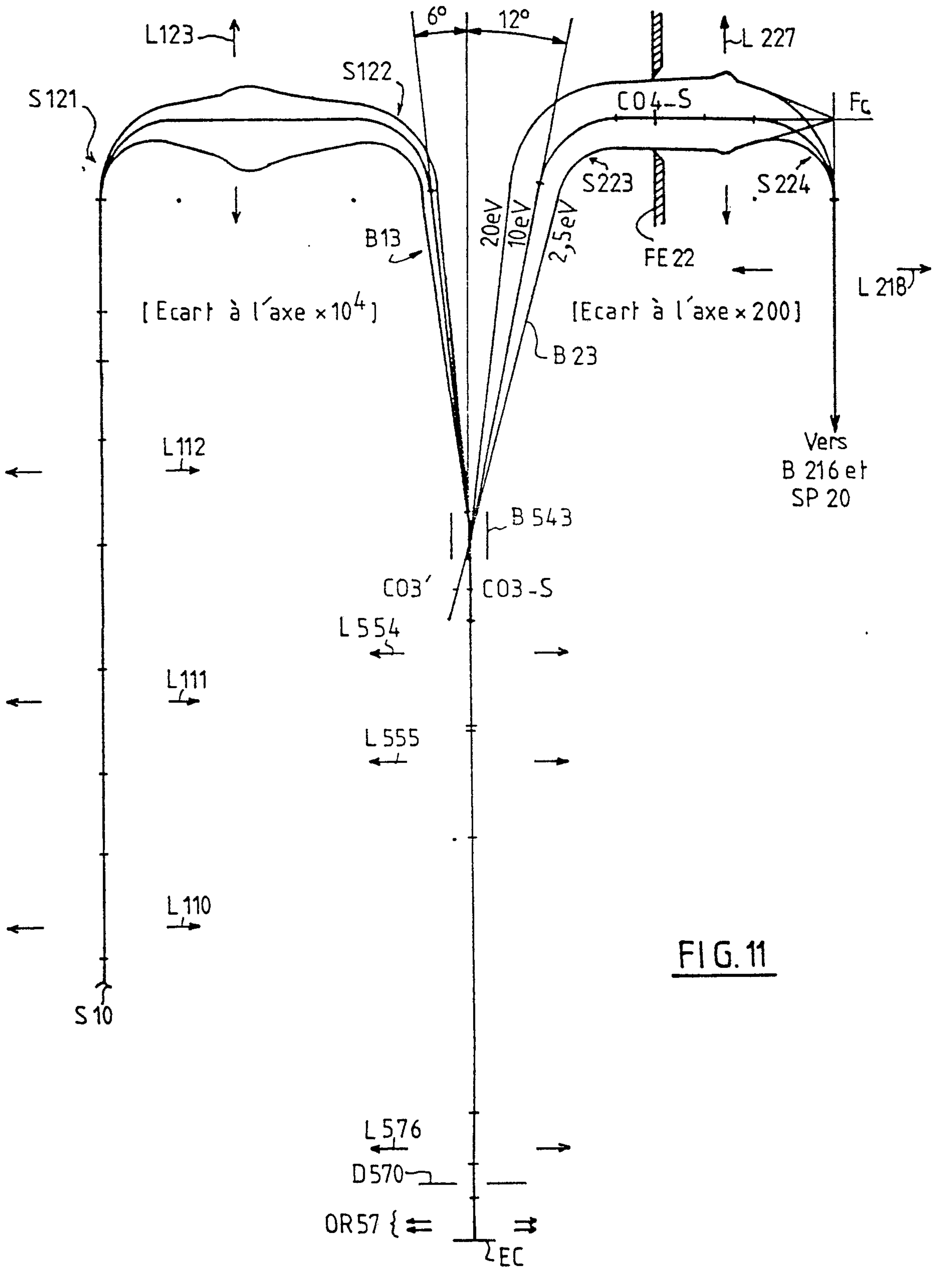
6°
12°
L123
L 227
S122
S121
C04-S
Fc
S223
S224
20eV
10eV
2,5eV
B13
FE22
L 218
[Ecart à l'axe × 10⁴]
[Ecart à l'axe × 200]
B 23
Vers
B 216 et
SP 20
L112
B 543
C03'
C03-S
L 554
L111
L 555
L 110
S 10
L 576
D570
OR57
EC

FIG. 11

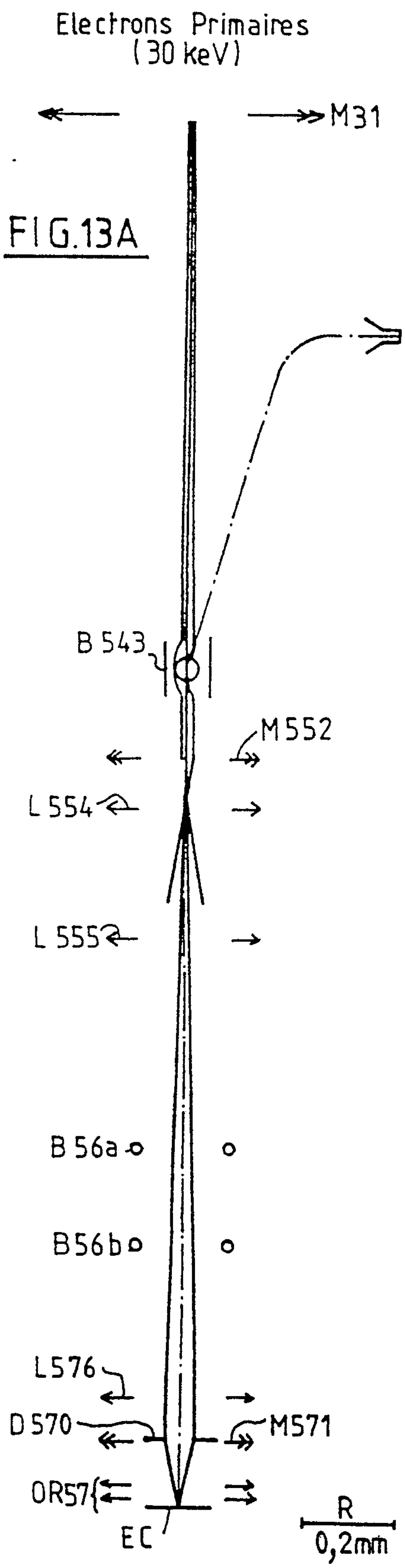


FIG.13A

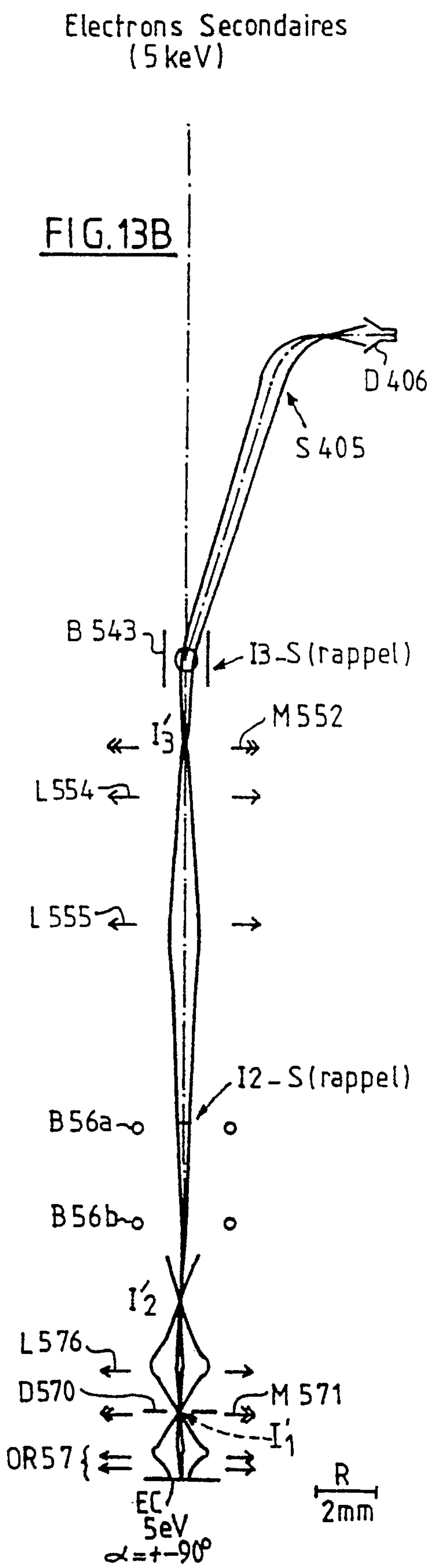


FIG.13B